# EUROPEAN PATENT APPLICATION

(11) **EP 4 354 729 A1**
(43) Date of publication of application: **17.04.2024**
(21) Application number: 22871039.8
(22) Date of filing: 27.09.2022
(51) Int. Cl.: H03H 9/15, H03H 3/00, H03H 9/02, H03H 9/17

(54) **BULK ACOUSTIC RESONATOR, FABRICATION METHOD THEREFOR, FILTER, AND ELECTRONIC DEVICE**

(30) Priority: 26.08.2022 CN 202211034177
(71) Applicant: JWL (Zhejiang) Semiconductor Co., Ltd., Huzhou, Zhejiang 313000 (CN)
(72) Inventor: LI, Linping, Zhejiang 313000 (CN); CUI, Meihui, Zhejiang 313000 (CN)
(74) Representative: Kolster Oy Ab
(86) International application number: PCT/CN2022/121571
(87) International publication number: WO 2024/040679

(57) **Abstract**

A bulk acoustic resonator, a method for manufacturing a bulk acoustic resonator, a filter, and an electronic device are provided. The bulk acoustic resonator includes a substrate, an acoustic reflection structure, a bottom electrode, a piezoelectric layer and a top electrode. The acoustic reflection structure, the bottom electrode, the piezoelectric layer and the top electrode are arranged sequentially in a direction away from the substrate. A first depression is defined on a surface of the bottom electrode away from the substrate. In forming the piezoelectric layer on a side of the bottom electrode away from the substrate, morphology of the first depression is transferred to a surface of the piezoelectric layer away from the substrate to form a second depression on a surface of the piezoelectric layer away from the substrate. The piezoelectric layer has an equal thickness. That is, the piezoelectric layer is not physically damaged such as being etched, so that a local stress distribution of the piezoelectric layer near the second depression is not damaged, and the stress distribution of the piezoelectric layer is uniform, thereby improving performance and yield of the bulk acoustic resonator. In addition, the first depression and the second depression are defined near an edge of the active region, suppressing transverse wave resonance and reducing leakage of transverse waves, thereby improving a quality factor of the bulk acoustic resonator.

## Description

The present application claims priority to Chinese Patent Application No. 202211034177.4, titled "BULK ACOUSTIC RESONATOR AND MANUFACTURING METHOD THEREOF, FILTER AND ELECTRONIC DEVICE", filed on August 26, 2022 with the Chinese Patent Office, which is incorporated herein by reference in its entirety.

### FIELD

The present disclosure relates to the field of semiconductor technology, and in particular to a bulk acoustic resonator, a method for manufacturing a bulk acoustic resonator, a filter, and an electronic device.

### BACKGROUND

With the increasing crowded electromagnetic spectrums, the increasing frequency bands and functions of wireless communication devices, and the rapid growth of the electromagnetic spectrums for wireless communication from 500MHz to more than 5GHz, the requirement for radio frequency front-end modules with high performance, low cost, low power consumption and small size is increasing. The filter, as a radio frequency front-end module, has the function of improving transmission and reception of signals and plays an important role. A filter, including multiple thin bulk acoustic resonators (Fbars) connected in a topological network structure, meets the high requirements for the radio frequency front-end modules due to that the filter has a small size, a strong integration ability, a high quality factor and a strong power tolerance at a high frequency, and the like. Therefore, the manufacture of high-performance bulk acoustic resonators becomes a hot research topic.

The bulk acoustic resonator usually includes an upper electrode, a lower electrode and a piezoelectric layer between the upper electrode and the lower electrode. That is, the bulk acoustic resonator has a "sandwich" structure. In a case that an electric field is applied between the upper electrode and the lower electrode, the piezoelectric layer converts electrical energy to mechanical energy in the form of acoustic waves. Due to that an upper surface of the upper electrode is in contact with the air, the acoustic waves are fully reflected at the junction of the upper electrode and the air, thereby inhibiting energy leakage. In addition, a lower surface of the lower electrode is provided with an acoustic reflection element to prevent energy from leaking to a substrate, thereby storing the energy in the bulk acoustic resonator. It can be seen that quality of the piezoelectric layer of the bulk acoustic resonator directly determines the performance and yield of the bulk acoustic resonator.

In manufacturing the bulk acoustic resonator, the piezoelectric layer is formed on a wafer. Due to that the material of the piezoelectric layer and the material of the substrate have different thermal expansion coefficients and different lattice constants and the influence of the temperature change of the external environment, the stress distribution in the piezoelectric layer is non-uniform and the stress distribution of the piezoelectric layer on the wafer fluctuates, seriously affecting the performance and the yield of the bulk acoustic resonator and then affecting the performance and the yield of the filter.

### SUMMARY

In order to solve the above technical problems, a bulk acoustic resonator, a method for manufacturing a bulk acoustic resonator, a filter, and an electronic device are provided according to the embodiments of the present disclosure to provide a bulk acoustic resonator including a piezoelectric layer with a uniform stress distribution.

In order to achieve the above objectives, the following technical solutions are provided according to the embodiments of the present disclosure.

According to a first aspect of the present disclosure, a bulk acoustic resonator is provided. The bulk acoustic resonator includes a substrate, an acoustic reflection structure, a bottom electrode, a piezoelectric layer and a top electrode. The acoustic reflection structure is arranged on the substrate or is embedded in the substrate. The bottom electrode, the piezoelectric layer and the top electrode are sequentially arranged on a side of a structure formed by the acoustic reflection structure and the substrate. A first depression is defined on a surface of the bottom electrode away from the substrate. The first depression is filled by the piezoelectric layer. A second depression is defined on a surface of the piezoelectric layer away from the substrate. The piezoelectric layer has an equal thickness in a direction perpendicular to a plane where the substrate is located. An orthographic projection of the first depression on the plane where the substrate is located covers an orthographic projection of the second depression on the plane where the substrate is located.

In an embodiment, a third depression is defined on a surface of the structure formed by the acoustic reflection structure and the substrate towards the bottom electrode. The third depression is filled by the bottom electrode. The bottom electrode has an equal thickness in the direction perpendicular to the plane where the substrate is located. An orthographic projection of the third depression on the plane where the substrate is located covers the orthographic projection of the first depression on the plane where the substrate is located.

In an embodiment, in the direction perpendicular to the plane where the substrate is located, an edge of the acoustic reflection structure is configured to be outside an edge of the top electrode or to coincide with the edge of the top electrode. The second depression is defined with a first side edge and a second side edge, the first side edge is opposite to the second side edge, and the second side edge is outside the first side edge has a first side edge and a second side edge that are opposite, and the second side edge is outside the first side edge. In the direction perpendicular to the plane where the substrate is located, the first side edge of the second depression is configured to be outside the edge of the top electrode or to coincide with the edge of the top electrode.

In an embodiment, in the direction perpendicular to the plane where the substrate is located, an edge of the acoustic reflection structure is configured to be outside an edge of the top electrode or to coincide with the edge of the top electrode. The second depression is defined with a first side edge and a second side edge, the first side edge is opposite to the second side edge, and the second side edge is outside the first side edge. In the direction perpendicular to the plane where the substrate is located, the second side edge of the second depression is configured to be inside the edge of the top electrode or to coincide with the edge of the top electrode.

In an embodiment, in the direction perpendicular to the plane where the substrate is located, a part of the top electrode corresponding to the second depression is configured to extend in a direction parallel to the plane where the substrate is located. Alternatively, in the direction perpendicular to the plane where the substrate is located, a part of the top electrode corresponding to the second depression is configured to protrude away from the substrate.

In an embodiment, in the direction perpendicular to the plane where the substrate is located, an edge of the acoustic reflection structure is configured to be outside an edge of the top electrode or to coincide with the edge of the top electrode. The second depression is defined with a first side edge and a second side edge, the first side edge is opposite to the second side edge, and the second side edge is outside the first side edge. In the direction perpendicular to the plane where the substrate is located, the first side edge of the second depression is configured to be inside the edge of the top electrode, and the second side edge of the second depression is configured to be outside the edge of the top electrode.

In an embodiment, in the direction perpendicular to the plane where the substrate is located, an edge of the top electrode is configured to be outside an edge of the acoustic reflection structure. The second depression is defined with a first side edge and a second side edge, the first side edge is opposite to the second side edge, and the second side edge is outside the first side edge. In the direction perpendicular to the plane where the substrate is located, the first side edge of the second depression is configured to be inside the edge of the acoustic reflection structure or to coincide with the edge of the acoustic reflection structure, and the second side edge of the second depression is configured to be outside the edge of the top electrode or to coincide with the edge of the top electrode.

In an embodiment, the top electrode includes a first part and a second part. The first part is configured to extend in a direction parallel to the plane where the substrate is located, the first part is configured to contact with the surface of the piezoelectric layer away from the substrate, and the second part is configured to be suspended above the second depression. The second part is configured to extend in a direction parallel to the plane where the substrate is located. Alternatively, the second part is configured to extend in a direction with an angle greater than 0° and less than 90 ° from the direction in which the first part extends.

In an embodiment, the first side edge of the second depression is configured to be inside the edge of the top electrode, and the second side edge of the second depression is configured to be outside the edge of the top electrode. The second part is configured to extend in a direction parallel to the plane where the substrate is located, and an end face of the second part away from the first part configured to be perpendicular to the plane where the substrate is located.

In an embodiment, the top electrode includes multiple edges. In the direction perpendicular to the plane where the substrate is located, the second depression is defined corresponding to at least one of the edges of the top electrode.

In an embodiment, the second depression includes at least one continuous groove corresponding to the edges of the top electrode; and/or the second depression includes multiple point-shaped grooves corresponding to at least one of the edges of the top electrode.

In an embodiment, the acoustic reflection structure is configured to be a cavity structure or a distributed Bragg reflection structure.

In an embodiment, each of the first depression and the second depression is configured to be in an inverted trapezoid shape, in an inverted triangle shape, in a square shape, or in an irregular shape.

In an embodiment, the second depression is filled with a filling medium. The filling medium includes air, phosphorus-doped silicon dioxide, carbon-doped silicon dioxide, dielectric resin, or benzocyclobutene.

In an embodiment, in the direction perpendicular to the plane where the substrate is located, a depth of the first depression is less than or equal to a thickness of the bottom electrode.

In an embodiment, an end of the bottom electrode is configured to be vertical, inclined, in a stepped shape, or in an arc shape.

According to a second aspect of the present disclosure, a method for manufacturing a bulk acoustic resonator is provided. The method includes: obtaining a substrate; arranging a bottom electrode on the substrate, arranging a first depression on a surface of the bottom electrode away from the substrate, and arranging an acoustic reflection structure or a sacrificial layer between the bottom electrode and the substrate; arranging a piezoelectric layer on a side of the bottom electrode away from the substrate, where the first depression is filled with the piezoelectric layer, a morphology of the first depression is transferred to a surface of the piezoelectric layer away from the substrate in forming the piezoelectric layer to form a second depression on the surface of the piezoelectric layer away from the substrate, the piezoelectric layer has an equal thickness in a direction perpendicular to a plane where the substrate is located, and an orthographic projection of the first depression on the plane where the substrate is located covers an orthographic projection of the second depression on the plane where the substrate is located; and arranging a top electrode on a side of the piezoelectric layer away from the substrate.

In an embodiment, before arranging the bottom electrode, the method further includes: arranging the acoustic reflection structure or the sacrificial layer, wherein the acoustic reflection structure or the sacrificial layer is arranged on the substrate or is embedded in the substrate; and arranging a third depression on a side of a structure formed by the acoustic reflection structure and the substrate or on a side of a structure formed by the sacrificial layer and the substrate. The arranging a bottom electrode includes: arranging the bottom electrode on the side of the structure formed by the acoustic reflection structure and the substrate or the sacrificial layer and the substrate, filling the third depression with the bottom electrode, transferring a morphology of the third depression to the surface of the bottom electrode away from the substrate to form the first depression on the surface of the bottom electrode away from the substrate, configuring the bottom electrode to have an equal thickness in the direction perpendicular to the plane where the substrate is located, and configuring an orthographic projection of the third depression on the plane where the substrate is located to cover the orthographic projection of the first depression on the plane where the substrate is located.

According to a third aspect of the present disclosure, a filter is provided. The filter includes the bulk acoustic resonator described above.

According to a fourth aspect of the present disclosure, an electronic device is provided. The electronic device includes the filter described above or the bulk acoustic resonator described above.

Compared with the conventional technology, the above technical solutions have the following advantages.

The bulk acoustic resonator according to the embodiments of the present disclosure includes a substrate, an acoustic reflection structure, a bottom electrode, a piezoelectric layer and a top electrode. The acoustic reflection structure, the bottom electrode, the piezoelectric layer and the top electrode are arranged sequentially in a direction away from the substrate. A first depression is defined on a surface of the bottom electrode away from the substrate. In forming the piezoelectric layer on a side of the bottom electrode away from the substrate, the morphology of the first depression is transferred to a surface of the piezoelectric layer away from the substrate, so that a second depression is formed on the surface of the piezoelectric layer away from the substrate. In this way, the piezoelectric layer has an equal thickness in the direction perpendicular to the plane where the substrate is located. That is, the piezoelectric layer is not physically damaged such as being etched, so that the local stress distribution of the piezoelectric layer near the first depression and the second depression is not damaged. For a single bulk acoustic resonator, it is easy to control the local stress of the piezoelectric layer, so that the stress distribution of the piezoelectric layer is uniform, thereby improving the performance of the bulk acoustic resonator.

In addition, for piezoelectric layers of bulk acoustic resonators formed on a wafer, second depressions may be formed on the piezoelectric layers of the bulk acoustic resonators by transferring morphologies of first depressions without physically damaging the piezoelectric layers. In the direction perpendicular to the plane where the substrate is located, the piezoelectric layers on the wafer have an equal thickness, so that the overall stress distribution of the piezoelectric layers on the wafer tends to be uniform rather than fluctuating. Fluctuation of the stress of the piezoelectric layers on the wafer is reduced, so that the stresses of the piezoelectric layers at different positions on the wafer have small differences, thereby improving the uniformity of the stress distribution of the piezoelectric layers on the wafer, and thereby improving the yield of the bulk acoustic resonators formed on the wafer.

Moreover, for the bulk acoustic resonator according to the embodiments of the present disclosure, the piezoelectric layer is not physically damaged such as being etched, ensuring the mechanical strength and device reliability of the bulk acoustic resonator.

Furthermore, in the bulk acoustic resonator, longitudinal waves propagating along a direction of the thickness of the piezoelectric layer play a major role. However, it is inevitable to excite transverse waves propagating along a direction parallel to the plane where the substrate is located, and the transverse waves are easy to leak from an edge of an active region, resulting in energy loss. In the bulk acoustic resonator according to the embodiments of the present disclosure, the first depression and the second depression may be defined near the edge of the active region in the direction perpendicular to the plane where the substrate is located. Thus, the second depression forms a boundary between the piezoelectric layer and the air or other medium filled in the second depression, and the first depression forms a boundary between the piezoelectric layer and the bottom electrode. Therefore, a double-layer depression structure including the first depression and the second depression may generate acoustic impedance changes near the edge of the active region, forming an interference structure to suppress transverse wave resonance and reduce the proportion of the transverse waves in the acoustic energy, thereby improving the quality factor of the bulk acoustic resonator. In addition, the first depression further forms a transverse wave trap structure, so that when the transverse waves are propagated from the active region to the first depression, the transverse waves are reflected many times in the transverse wave trap structure formed by the first depression and then are reflected back to the active region. In this way, the leakage of the transverse waves is reduced, that is, loss of the acoustic energy is reduced, and the transverse wave resonance is further suppressed and the proportion of the transverse waves in the acoustic energy is reduced, improving the quality factor of the bulk acoustic resonator. Moreover, due to a morphology change of the piezoelectric layer around the first depression, the piezoelectric layer around the first depression may reflect the transverse waves, reducing the leakage of the transverse waves and improving the quality factor of the bulk acoustic resonator.

### BRIEF DESCRIPTION OF THE DRAWINGS

In order to more clearly describe the technical solutions in the embodiments of the present disclosure or the technical solutions in the conventional technology, drawings to be used in the description of the embodiments of the present disclosure or the conventional technology are briefly described hereinafter. It is apparent that the drawings described below are merely used for describing the embodiments of the present disclosure, and those skilled in the art may obtain other drawings according to the provided drawings without any creative effort.
Figure 1(a) to Figure 1(h) are schematic structural diagrams of a section of a bulk acoustic resonator according to different embodiments of the present disclosure;
Figure 2(a) to Figure 2(e) are schematic structural diagrams of a section of a bulk acoustic resonator according to different embodiments of the present disclosure;
Figure 3(a) to Figure 3(d) are schematic structural diagrams of a section of a bulk acoustic resonator according to different embodiments of the present disclosure;
Figure 4(a) to Figure 4(e) are schematic structural diagrams of a section of a bulk acoustic resonator according to different embodiments of the present disclosure;
Figure 5 to Figure 8 are schematic structural diagrams of a section of a bulk acoustic resonator according to different embodiments of the present disclosure;
Figure 9 is a schematic diagram of a piezoelectric layer and a substrate bent by tensile stress;
Figure 10 is a schematic diagram of a piezoelectric layer and a substrate bent by compressive stress;
Figure 11 is a schematic diagram showing a comparison between an overall stress distribution of piezoelectric layers of bulk acoustic resonators formed on a wafer according to the conventional technology and an overall stress distribution of piezoelectric layers of bulk acoustic resonators formed on a wafer according to an embodiment of the present disclosure;
Figure 12 is a top view of an overall stress distribution of piezoelectric layers of bulk acoustic resonators formed on a wafer according to the conventional technology;
Figure 13 is a top view of an overall stress distribution of piezoelectric layers of bulk acoustic resonators formed on a wafer, where each of the piezoelectric layers is etched to form a depression;
Figure 14 is a top view of an overall stress distribution of piezoelectric layers of bulk acoustic resonators according to an embodiment of the present disclosure on a wafer;
Figure 15 is a schematic diagram showing a relationship between impedances of a bulk acoustic resonator and frequencies according to an embodiment of the present disclosure and a relationship between impedances of a bulk acoustic resonator having a sandwich structure and frequencies according to the conventional technology;
Figure 16 is an enlarged schematic diagram of a part marked by a solid circle in Figure 15;
Figure 17 shows a Smith circle diagram of a bulk acoustic resonator according to an embodiment of the present disclosure and a Smith circle diagram of a bulk acoustic resonator having a sandwich structure according to the conventional technology;
Figure 18 is a top view of a top electrode and a second depression in a bulk acoustic resonator according to an embodiment of the present disclosure;
Figure 19 is a top view of a top electrode and a second depression in a bulk acoustic resonator according to another embodiment of the present disclosure; and
Figure 20 is a top view of a top electrode and a second depression in a bulk acoustic resonator according to another embodiment of the present disclosure.

### DETAILED DESCRIPTION OF EMBODIMENTS

Technical solutions in the embodiments of the present disclosure are described clearly and completely below in conjunction with the drawings of the embodiments of the present disclosure. Apparently, the embodiments described below are only some embodiments of the present disclosure, rather than all the embodiments. Any other embodiments obtained by those skilled in the art based on the embodiments in the present disclosure without any creative effort fall within the protection scope of the present disclosure.

Many specific details are described in the following description in order to provide a thorough understanding of the present disclosure, but the present disclosure may be implemented in other ways different from those described herein. Those skilled in the art can make similar embodiments without departing from the spirit of the present disclosure, and thus the present disclosure is not limited by the specific embodiments disclosed below.

Further, the present disclosure will be described in detail in conjunction with the drawings. In the detailed description of the embodiments of the present disclosure, the sectional diagram of the structure of the device is partially enlarged not in a general scale. The schematic diagrams are only used for illustration, and the protection scope of the present disclosure should not be limited hereto. In addition, the three-dimensional dimensions of length, width and depth should be considered in the actual production.

As described in the background, it is urgent to provide a bulk acoustic resonator including a piezoelectric layer with a uniform stress distribution.

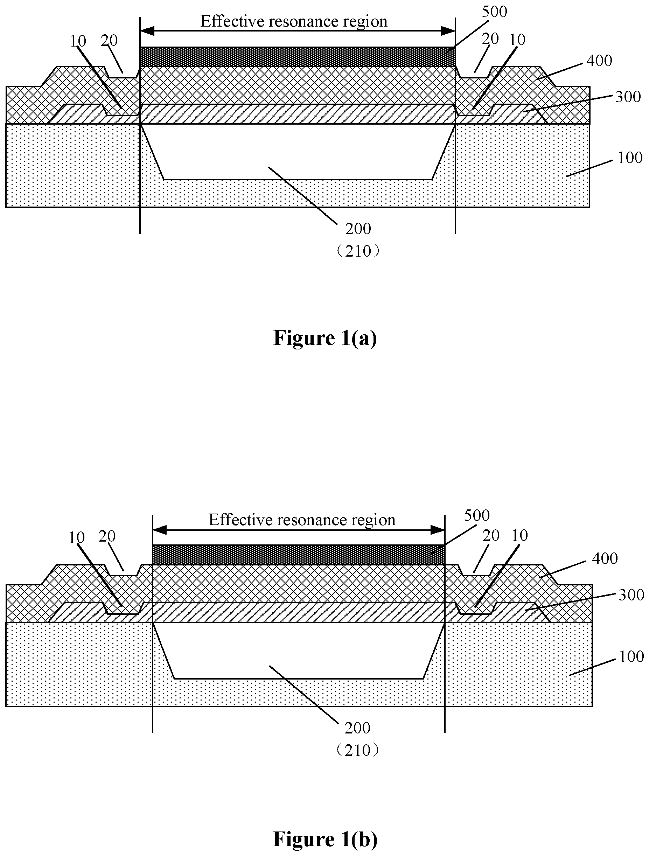

In view of this, a bulk acoustic resonator is provided according to the embodiments of the present disclosure. Figure 1(a) to Figure 1 (h), Figure 2(a) to Figure 2(e), Figure 3(a) to Figure 3(d), Figure 4(a) to Figure 4(e), and Figure 5 to Figure 8 show schematic structural diagrams of a section of a bulk acoustic resonator according to different embodiments of the present disclosure. It can be seen from the Figures that the bulk acoustic resonator includes a substrate 100, an acoustic reflection structure 200, a bottom electrode 300, a piezoelectric layer 400 and a top electrode 500. The acoustic reflection structure 200 is arranged on the substrate 100 or is embedded in the substrate 100. The bottom electrode 300, the piezoelectric layer 400 and the top electrode 500 are sequentially arranged on a side of a structure formed by the acoustic reflection structure 200 and the substrate 100. A first depression 10 is defined on a surface of the bottom electrode 300 away from the substrate 100, and the first depression 10 is filled by the piezoelectric layer 400. A second depression 20 is defined on a surface of the piezoelectric layer 400 away from the substrate 100. In a direction perpendicular to a plane where the substrate 100 is located, the piezoelectric layer 400 has an equal thickness. An orthographic projection of the first depression 10 on the plane where the substrate 100 is located covers an orthographic projection of the second depression 20 on the plane where the substrate 100 is located.

In the embodiments of the present disclosure, when an electric field is applied by the bottom electrode 300 and the top electrode 500, the piezoelectric layer 400 arranged between the bottom electrode 300 and the top electrode 500 converts electrical energy to mechanical energy in a form of acoustic waves. A surface of the top electrode 500 away from the substrate 100 contacts with the air to form a reflection surface, and the acoustic reflection structure 200 is arranged between the bottom electrode 300 and the substrate 100. Both the reflection surface and the acoustic reflection structure reflect the acoustic waves, so that the acoustic waves are stored in an overlapping region of the acoustic reflection structure 200, the bottom electrode 300, the piezoelectric layer 400 and the top electrode 500 in the direction perpendicular to the plane where the substrate 100 is located. It is known that the overlapping region of the acoustic reflection structure 200, the bottom electrode 300, the piezoelectric layer 400 and the top electrode 500 in the direction perpendicular to the plane where the substrate 100 is located forms an active region, so that the acoustic waves are stored in the active region.

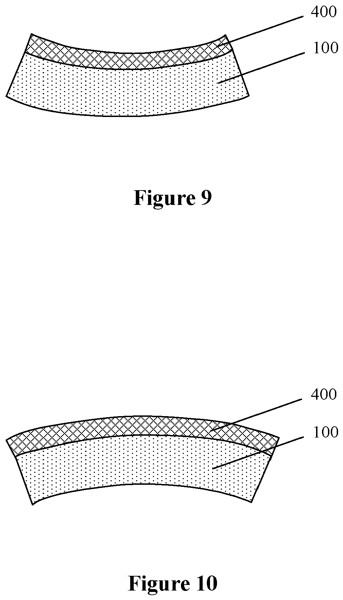

It should be noted that since a lattice constant of a material (for example, an AlN material) of the piezoelectric layer 400 does not match a lattice constant of a material of the substrate 100 and a thermal expansion coefficient of the material of the piezoelectric layer 400 is different from a thermal expansion coefficient of the material of the substrate 100, the piezoelectric layer 400 and the substrate 100 are to be bent upward by tensile stress (as shown in Figure 9) or to be bent downward by compressive stress (as shown in Figure 10) due to changes of the temperature of the external environment, for example, changes of the temperature in forming or using the piezoelectric layer. Figure 9 and Figure 10 only show the piezoelectric layer 400 and the substrate 100 to display the stress change. The stress on the piezoelectric layer has a great influence on an effective electromechanical coupling coefficient Kt² of the piezoelectric layer. For example, in a case that the stress on the AlN piezoelectric film changes from compressive stress of -2200MPa to tensile stress of 1000MPa, the effective electromechanical coupling coefficient Kt² of the AlN piezoelectric film increases from 4.86% to 7.22%. The great change in the effective electromechanical coupling coefficient Kt² of the AlN piezoelectric film seriously affects the performance of the bulk acoustic resonator, and then affects the performance of the filter, such as affecting a passband fluctuation, an insertion loss and a bandwidth of the filter. Therefore, in order to improve the performance of the bulk acoustic resonator, it is required to ensure the consistency of the effective electromechanical coupling coefficient Kt² of the piezoelectric layer 400. That is, the stress distribution of the piezoelectric layer 400 is required to be uniform. Especially, for a wafer with a large size, such as a 6-inch wafer, an 8-inch wafer and a 12-inch wafer, the stress generated by the piezoelectric layer increases with an increase of the size of the wafer, so that it is important to control the stress of the piezoelectric layer to be uniform.

Therefore, in the embodiments of the present disclosure, in the direction perpendicular to the plane where the substrate 100 is located, the piezoelectric layer 400 has an equal thickness and is not physically damaged such as being etched. For the second depression formed on the surface of the piezoelectric layer 400 away from the substrate 100, a first depression 10 is formed on the surface of the bottom electrode 300 away from the substrate 100, then a piezoelectric layer 400 is formed on a side of the bottom electrode 300 away from the substrate 100, thus the morphology of the first depression 10 is transferred to the surface of the piezoelectric layer 400 away from the substrate 100, so that the second depression 20 is formed on the surface of the piezoelectric layer 400 away from the substrate 100. In this way, the piezoelectric layer 400 formed between the first depression 10 and the second depression 20 has the same thickness as the piezoelectric layer 400 formed on both sides of the first depression 10 and the second depression 20, so that the local stress distribution of the piezoelectric layer 400 near the first depression 10 and the second depression 20 is not damaged. For a single bulk acoustic resonator, it is easy to control the local stress of the piezoelectric layer 400, so that the stress distribution of the piezoelectric layer 400 is uniform. Due to the uniform stress distribution of the piezoelectric layer 400, the distribution of the effective electromechanical coupling coefficient Kt² of the piezoelectric layer 400 is uniform, thereby improving the performance of the bulk acoustic resonator.

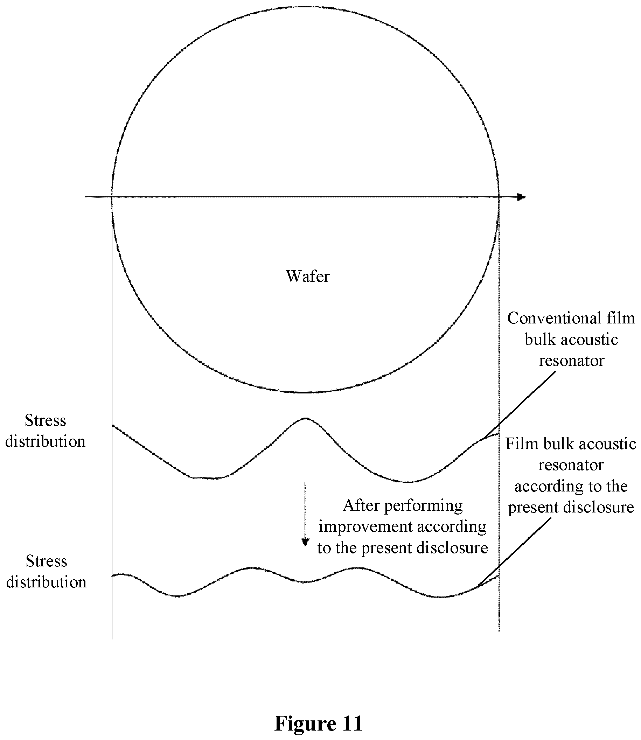

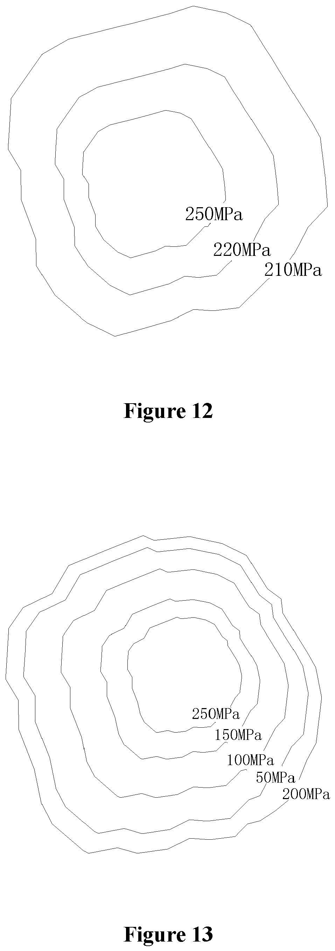

Moreover, for the piezoelectric layers of the bulk acoustic resonators formed on a wafer, the stress distributions of the piezoelectric layers of the bulk acoustic resonators are inconsistent due to various factors such as stress superposition in forming the piezoelectric layers 400 according to the conventional technology. Figure 11 is a schematic diagram showing an overall stress distribution of piezoelectric layers of bulk acoustic resonators formed on a wafer according to the conventional technology. It can be seen from Figure 11 that in the conventional technology, the stress distribution of the piezoelectric layers fluctuates from an edge region of the wafer to a center region of the wafer. Figure 12 is a top view of an overall stress distribution of piezoelectric layers of bulk acoustic resonators formed on a wafer according to the conventional technology. It can be seen from Figure 12 that in the conventional technology, the stress distribution of the piezoelectric layers on the wafer is circular and fluctuating, and the stress changes near the center region of the wafer. The non-uniform overall stress distribution of the piezoelectric layers on the wafer results in a great difference in performances of bulk acoustic resonators corresponding to positions where the stress of piezoelectric layers on the wafer changes greatly, reducing the yield of the bulk acoustic resonators.

Figure 13 is a top view of an overall stress distribution of piezoelectric layers of bulk acoustic resonators formed on a wafer, where each of the piezoelectric layers is etched to form a depression. It can be seen from Figure 13 that an overall stress distribution of the piezoelectric layers on the wafer changes greatly and the stress near a center region of the wafer still changes. The piezoelectric layers are etched to form depressions, then the piezoelectric layers are physically damaged, thus the stress of the piezoelectric layers near the depressions changes greatly in a large range, and the stress changes irregularly.

Therefore, in the embodiments of the present disclosure, for the piezoelectric layers of the bulk acoustic resonators form on a wafer, the second depressions 20 may be formed on the piezoelectric layers 400 of the bulk acoustic resonators by transferring the morphologies of the first depressions 10 without physically damaging the piezoelectric layers. In addition, in the direction perpendicular to the plane where the substrate 100 is located, the piezoelectric layers 400 on the wafer have an equal thickness, so that the overall stress distribution of the piezoelectric layers on the wafer tends to be uniform rather than fluctuating.

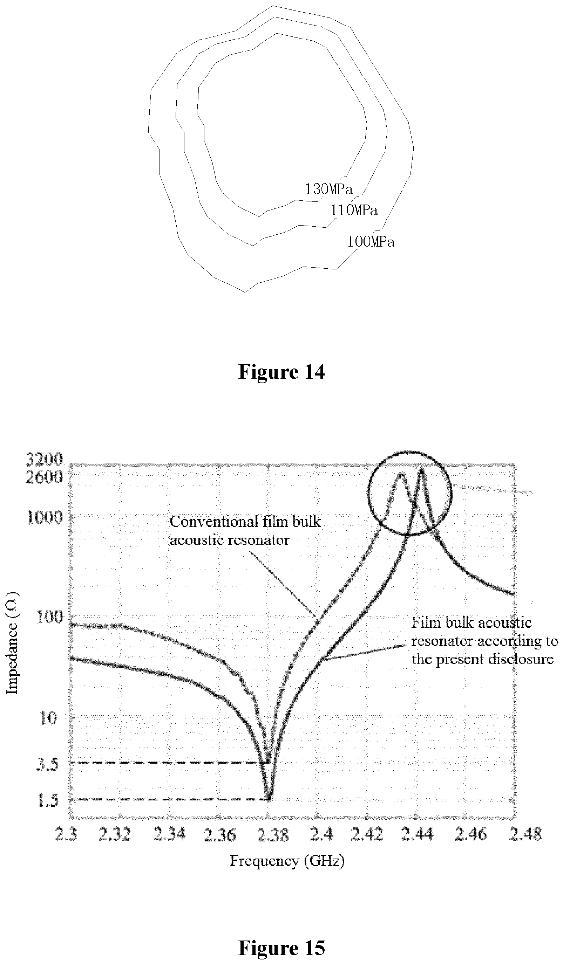

Figure 11 and Figure 14 show schematic diagrams of an overall stress distribution of piezoelectric layers of bulk acoustic resonators formed on a wafer according to an embodiment of the present disclosure. Figure 14 is a top view. It can be seen from Figure 11 and Figure 14 that the overall stress distribution of the piezoelectric layers on the wafer tends to be uniform. Although the stress of the piezoelectric layers corresponding to an edge region of the wafer changes, the change is small. The stress distribution of the piezoelectric layers corresponding to a center region of the wafer is uniform. That is, the stress of the piezoelectric layers of the bulk acoustic resonators on the wafer fluctuates slightly, so that the difference between stress of the piezoelectric layers formed on different positions of the wafer is small, thereby improving uniformity of the stress distribution of the piezoelectric layers on the wafer, and improving the yield of the bulk acoustic resonators on the wafer.

In addition, in the bulk acoustic resonator according to the embodiments of the present disclosure, the piezoelectric layer is not physically damaged such as being etched, so that the mechanical strength and device reliability of the bulk acoustic resonator are ensured, improving the performance and the yield of the bulk acoustic resonator.

It should be noted that in an ideal operation mode of the bulk acoustic resonator, the acoustic waves propagate along a direction of the thickness of the piezoelectric layer, that is, a longitudinal mode. In the longitudinal mode, the acoustic waves may be stored in the active region. However, in addition to the longitudinal mode, the acoustic waves propagate in the bulk acoustic resonator in a transverse mode. That is, there are transverse waves propagating along a direction parallel to the plane where the substrate is located. The longitudinal mode and the transverse mode exist simultaneously. It should be understood that the transverse waves propagate transversely in the active region, reducing the proportion of the longitudinal waves in total acoustic energy, thereby resulting in energy loss and energy dissipation of the bulk acoustic resonator and reducing the quality factor (that is, the Q factor) of the bulk acoustic resonator. The quality factor (that is, the Q factor) of the bulk acoustic resonator is usually defined as a quotient obtained by dividing maximum acoustic energy stored in the bulk acoustic resonator in a period of an applied radio frequency (RF) signal by total energy dissipated or lost in the period. In a case that resonance occurs in the transverse mode, the proportion of the transverse waves in the total acoustic energy is increased, thus the proportion of the longitudinal waves in the total acoustic energy is reduced, further increasing the energy loss of the bulk acoustic resonator. The transverse waves propagate in the direction parallel to the plane where the substrate is located, thus the transverse waves are easily leaked from a side edge of the active region, resulting in energy loss of the bulk acoustic resonator.

Therefore, in the bulk acoustic resonator according to the embodiments of the present disclosure, the first depression 10 and the second depression 20 may be arranged near an edge of the top electrode 500 in the direction perpendicular to the plane where the substrate 100 is located. Generally, the orthographic projection of the acoustic reflection structure 200 on the plane where the substrate 100 is located covers the orthographic projection of the top electrode 500 on the plane where the substrate 100 is located to avoid parasitic oscillation caused by a part of the top electrode 500 beyond the acoustic reflection structure 200 contacting with the piezoelectric layer 400. Therefore, the active region is usually determined based on an end of the top electrode 500. In this embodiment, the second depression 20 is formed by transferring the morphology of the first depression 10, so that a position of the first depression 10 corresponds to a position of the second depression 20 in the direction perpendicular to the plane where the substrate 100 is located. The first depression 10 and the second depression 20 may be arranged near the edge of the top electrode 500. That is, the first depression 10 and the second depression 20 may be arranged near the edge of the active region.

The second depression 20 forms a boundary between the piezoelectric layer 400 and the air or other medium filled in the second depression 20. The first depression 10 forms a boundary between the piezoelectric layer 400 and the bottom electrode 300. An acoustic impedance is related to a material of a medium. The acoustic impedance of the air or other medium filled in the second depression 20 is different from the acoustic impedance of the piezoelectric layer 400, and the acoustic impedance of the bottom electrode 300 is different from the acoustic impedance of the piezoelectric layer 400. Therefore, an interference structure may be formed by the first depression 10 and the second depression 20 due to changes in acoustic impedance near the edge of the active region, suppressing transverse wave resonance, reducing the proportion of the transverse waves in the acoustic energy, and thereby improving the quality factor of the bulk acoustic resonator. In addition, the first depression 10 and the second depression 20 form a double-layer depression structure, achieving an interference effect. Therefore, with the interference structure and the double-layer depression structure, the suppression of the transverse waves is further enhanced.

In addition, the first depression 10 is filled with the material of the piezoelectric layer. The material of the piezoelectric layer 400 is different from the material of the bottom electrode 300, so that the acoustic impedance of the piezoelectric layer 400 is different from the acoustic impedance of the bottom electrode 300. For example, the piezoelectric layer is an AlN piezoelectric layer, the bottom electrode is a Mo metal layer, the acoustic impedance of the AlN piezoelectric layer is 36 Mrayls, and the acoustic impedance of the Mo metal layer of the bottom electrode is 63 Mrayls, thus the material of the bottom electrode and the material of the piezoelectric layer at the first depression 10 form a transverse wave trap structure. When the transverse waves propagates from the active region to the first depression 10, the transverse waves are reflected many times by the transverse wave trap structure formed at the first depression 10 back to the active region. Thus, the leakage of the transverse waves is reduced, that is, the loss of the acoustic energy is reduced. In addition, the transverse wave resonance is further suppressed and the proportion of the transverse waves in the acoustic energy is reduced, improving the quality factor of the bulk acoustic resonator. Moreover, the morphology of the piezoelectric layer around the first depression 10 is changed, thus the transverse waves are reflected, reducing the leakage of the transverse waves and improving the quality factor of the bulk acoustic resonator.

Figure 15 is a schematic diagram showing a relationship between impedances of a bulk acoustic resonator with frequencies according to an embodiment of the present disclosure and a relationship between impedances of a bulk acoustic resonator having a sandwich structure and frequencies according to the conventional technology. It can be seen from the Figure 15 that the series impedance Rs in the conventional bulk acoustic resonator having a sandwich structure is 3.5Ω, and the series impedance Rs in the bulk acoustic resonator according to the embodiment of the present disclosure is 1.5Ω. That is, the series impedance Rs in the bulk acoustic resonator according to the embodiment of the present disclosure is less than the series impedance Rs of the conventional bulk acoustic resonator having a sandwich structure.

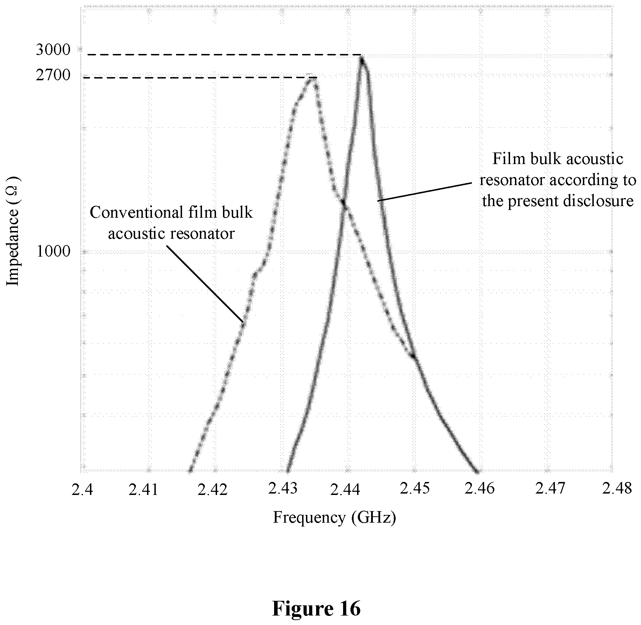

Figure 16 is an enlarged schematic diagram of a part marked by a solid circle in Figure 15. It can be seen from the Figure 16 that the parallel impedance Rp in the conventional bulk acoustic resonator having a sandwich structure is 2700Ω, and the parallel impedance Rp in the bulk acoustic resonator according to the embodiment of the present disclosure is 3000Ω. That is, the parallel impedance Rp in the bulk acoustic resonator according to the embodiment of the present disclosure is greater than the parallel impedance Rp in the conventional bulk acoustic resonator having a sandwich structure.

It can be seen that compared with the conventional bulk acoustic resonator having a sandwich structure, in the bulk acoustic resonator according to the embodiments of the present disclosure, the first depression 10 is formed on the surface of the bottom electrode 300 away from the substrate 100, the second depression 20 is formed on the surface of the piezoelectric layer 400 away from the substrate 100 through morphology transfer, so that the series impedance Rs of the bulk acoustic resonator is reduced and the parallel impedance Rp of the bulk acoustic resonator is increased. It is known that a Q value (represented by Qs and Qp) of a resonator is highly correlated with an impedance value (represented by Rs and Rp) of the resonator. In a case that the bulk acoustic resonator has a constant area, Rs is negatively correlated with Qs, and Rp is positively correlated with Qp. Therefore, in this embodiment, an reduction of the series impedance Rs of the bulk acoustic resonator causes an increase of Qs, or an increase of the parallel impedance Rp of the bulk acoustic resonator causes an increase of Qp. The increase of Qs or Qp indicates an increase of the Q factor of the bulk acoustic resonator. In general, a greater Q factor (represented by Qs and Qp) of a bulk acoustic resonator indicates a smaller acoustic loss, achieving a better performance of the bulk acoustic resonator, achieving a smaller passband insertion loss of a filter formed by cascading the bulk acoustic resonators, and thereby achieving better overall performance.

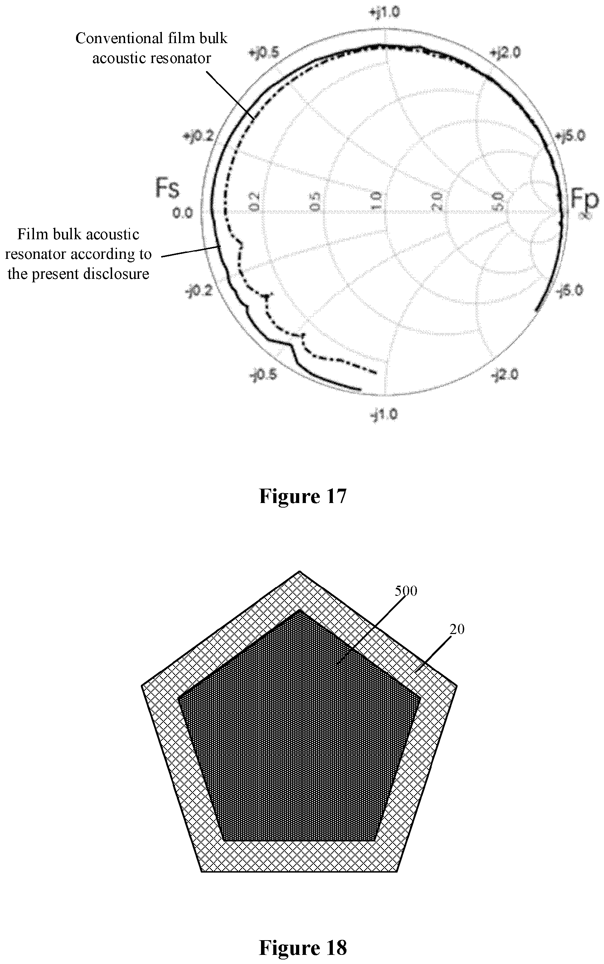

Figure 17 shows a Smith circle diagram of a bulk acoustic resonator according to an embodiment of the present disclosure and a Smith circle diagram of a bulk acoustic resonator having a sandwich structure according to the conventional technology. It can be seen from Figure 17 that compared with the bulk acoustic resonator having a sandwich structure according to the conventional technology, a curve of the bulk acoustic resonator according to the embodiment of the present disclosure is closer to an edge of a Smith circle and is more gentle, indicating that the bulk acoustic resonator according to the embodiment of the present disclosure has less parasitic oscillation, that is, indicating that the intensity of the parasitic resonance of the bulk acoustic resonator according to the embodiment of the present disclosure is greatly improved.

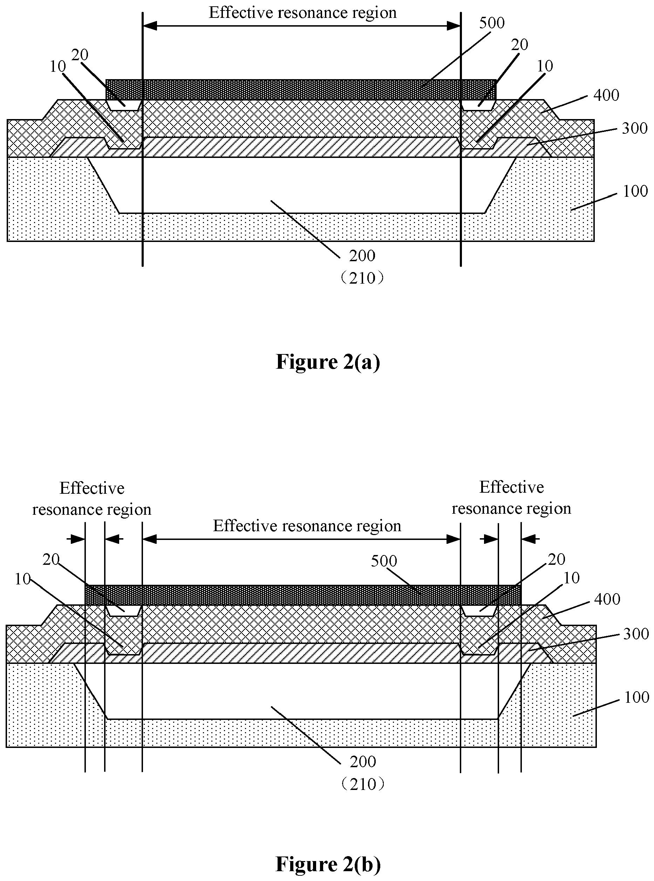

It should be further noted that in the bulk acoustic resonator according to the embodiments of the present disclosure, it is not limited to arrange the first depression 10 and the second depression 20 near the edge of the active region. In the direction perpendicular to the plane where the substrate 100 is located, the first depression 10 and the second depression 20 may be arranged inside the active region. For example, as shown in Figure 2(b), the first depression 10 and the second depression 20 are arranged inside the edge of the top electrode 500. Apparently, since the acoustic reflection structure 200, the bottom electrode 300, the piezoelectric layer 400 and the top electrode 500 corresponding to the positions of the first depression 10 and the second depression 20 do not overlap, both the first depression 10 and the second depression 20 are located in non-active regions, and both sides of the first depression 10 and the second depression 20 may be located in active regions.

In the bulk acoustic resonator according to the embodiments of the present disclosure, the first depression 10 is formed on the surface of the bottom electrode 300 away from the substrate 100, and the second depression 20 is formed on the surface of the piezoelectric layer 400 away from the substrate 100 through morphology transfer. In this way, the second depression 20 is formed on the surface of the piezoelectric layer 400 away from the substrate 100 without physically damaging the piezoelectric layer 400, solving the problem of non-uniform stress distribution of the piezoelectric layer 400 caused by forming a depression on the piezoelectric layer 400 by performing physical damage such as etching the piezoelectric layer 400 according to the conventional technology, improving the uniformity of the stress distribution of the piezoelectric layer 400, and improving the performance and the yield of the bulk acoustic resonator. In addition, the first depression 10 and the second depression 20 may be arranged near the edge of the active region, suppressing transverse wave resonance and reducing the leakage of the transverse waves. That is, the loss of the acoustic energy is reduced, and the proportion of the transverse waves in the acoustic energy is reduced, thereby improving the quality factor of the bulk acoustic resonator.

In the embodiment, the morphology of the first depression 10 is transferred in the deposition of the piezoelectric layer 400, thus the second depression 20 is formed on the surface of the piezoelectric layer 400 away from the substrate 100. Therefore, the morphology of the second depression 10 is ideally identical to the morphology of the first depression 20. That is, an orthographic projection of the first depression 10 on the plane where the substrate is located completely coincides with an orthographic projection of the second depression 20 on the plane where the substrate is located. However, considering the actual process, the orthographic projection of the first depression 10 on the plane where the substrate is located may be greater than the orthographic projection of the second depression 20 on the plane where the substrate is located. That is, the orthographic projection of the first depression 10 on the plane where the substrate is located covers the orthographic projection of the second depression 20 on the plane where the substrate is located.

Specifically, in the direction perpendicular to the plane where the substrate is located, a depth of the second depression 20 is less than or equal to a depth of the first depression 10. In the direction parallel to the plane where the substrate is located, a width of the second depression 20 is less than or equal to a width of the first depression 10.

For the first depression 10, the depth of the first depression 10 may be less than or equal to a thickness of the bottom electrode 300 in the direction perpendicular to the plane where the substrate is located. In an embodiment, the depth of the first depression 10 ranges from 10nm to 50nm, and the width of the first depression 10 may be set to be 1.5 times to 3 times of the depth of the first depression, alleviating the change of the morphology of the piezoelectric layer 400 in filling the first depression 10, and minimizing the stress change of the piezoelectric layer 400. In some cases, the depth of the first depression 10 is set to range from 50nm to 100nm, or even more than 150nm (for example, 300nm). In these cases, the width of the first depression 10 may be widened to alleviate the change of the morphology of the piezoelectric layer 400 at the first depression 10, thereby balancing performance and stability. For the second depression 20, the thickness of the second depression 20 is less than or equal to the thickness of the first depression, and the width of the second depression 20 is less than or equal to the width of the first depression.

In the embodiment, each of the first depression 10 and the second depression 20 may be in an inverted trapezoid shape, in an inverted triangle shape, in a square shape or in an irregular shape, which is determined according to actual situations. In a case that side walls of the first depression 10 and the second depression 20 are inclined, the change of the morphology of the piezoelectric layer 400 at the first depression 10 and the second depression 20 is alleviated, thereby minimizing the stress change of the piezoelectric layer 400.

In the embodiment, the second depression 20 is filled with a filling medium. The filling medium may include a dielectric material with low acoustic impedance, a low dielectric constant or a high insulation. Specifically, the filling medium includes air, phosphorus-doped silicon dioxide (PSG), carbon-doped silicon dioxide (that is, polymers of SiOC, SiC and SiN), dielectric resin (for example, dielectric resin commercially known as SiLK), benzocyclobutene (BCB), or the like, which is determined according to actual situations. However, it should be noted that the second depression 20 should not be filled with any metal material.

In the embodiment, in the direction parallel to the plane where the substrate is located, an end of the bottom electrode 300 (that is, an edge of the bottom electrode 300) is required to exceed an out edge of the first depression 10. That is, the first depression 10 is required to be arranged inside the edge of the bottom electrode 300, and the end of the piezoelectric layer 400 is required to exceed the end of the bottom electrode 300. Specifically, in the direction parallel to the plane where the substrate is located, a distance between the outer edge of the first depression 10 and the end of the bottom electrode 300 may range from 2 µ m to 5 µ m.

In the embodiment, the end of the bottom electrode 300 may be perpendicular to the plane where the substrate is located, that is, the end of the bottom electrode 300 is vertical. Alternatively, an angle between the end of the bottom electrode 300 and the plane where the substrate is located ranges from 0 degree to 90 degrees, that is, the end of the bottom electrode 300 is inclined. Alternatively, the end of the bottom electrode 300 may be in a stepped shape or in an arc shape. In a case that the end of the bottom electrode 300 is inclined, in the stepped shape or in the arc shape, in subsequently depositing the piezoelectric layer 400, the discontinuity of the material caused by the deposition of the piezoelectric layer 400 at the end of the bottom electrode 300 may be weakened, thereby improving the piezoelectric consistency of the piezoelectric layer 400.

In the embodiment, as shown in Figure 1(a) to Figure 1(h), Figure 2(a) to Figure 2(e), Figure 3(a) to Figure 3(d), Figure 4(a) to Figure 4(e), Figure 6 and Figure 7, the acoustic reflection structure 200 may be a cavity structure 210. In an embodiment, the cavity structure 210 may be embedded in the substrate. Then, a groove is defined on a surface of the substrate 100 towards the bottom electrode 300, and the groove subsequently forms the cavity structure. In an embodiment, the cavity structure 210 may be defined above the surface of the substrate 100. Then, the surface of the substrate 100 towards the bottom electrode 300 is horizontal, the bottom electrode 300 protrudes in a direction away from the substrate 100, and a cavity structure is formed between the surface of the substrate 100 and the protruded bottom electrode 300.

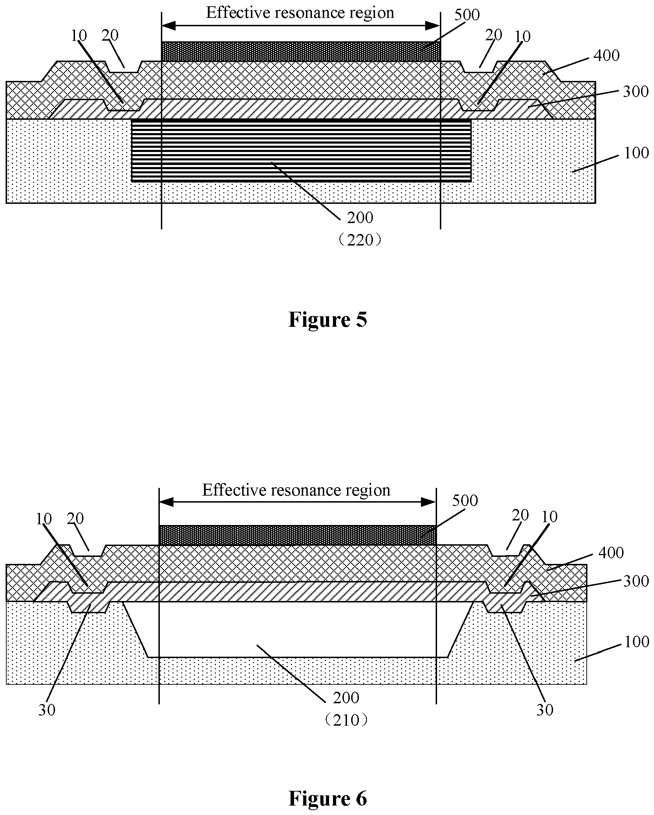

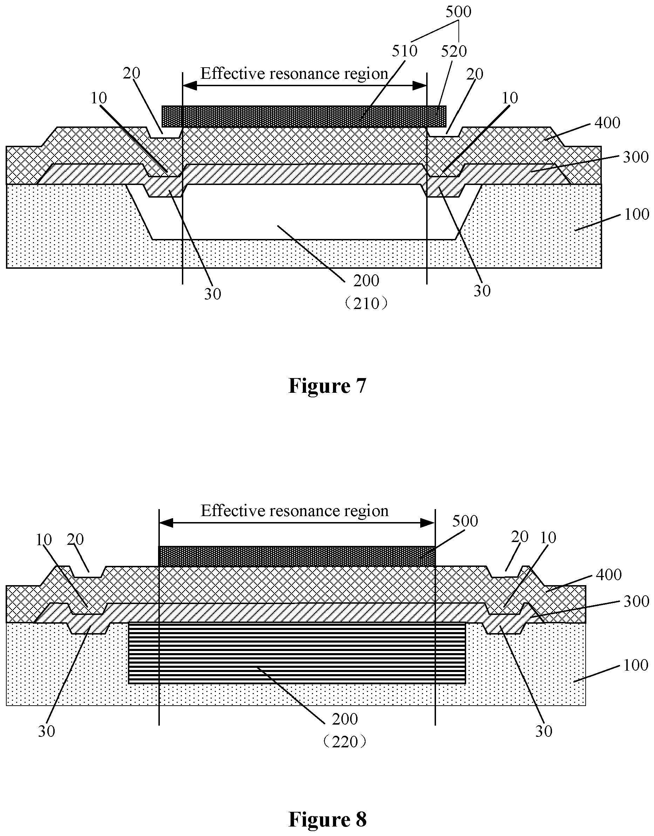

In an embodiment, as shown in Figure 5 and Figure 8, the acoustic reflection structure 200 may be a distributed Bragg reflection (DBR) structure 220 to form a solid assembled resonator (SMR). The distributed Bragg reflection structure 220 may be arranged on the substrate 100 or is embedded in the substrate 100. The distributed Bragg reflection structure 220 is formed by alternatively laminating a material with low acoustic resistance and a material with high acoustic resistance. Using the distributed Bragg reflection structure instead of the cavity structure as the acoustic reflection structure, the problems of poor mechanical stability and reliability of the active region above the cavity structure caused by the collapse of the active region under a pressure may be solved. That is, the mechanical stability and reliability of the active region in the bulk acoustic resonator may be improved.

On the basis of the above embodiments, in an embodiment of the present disclosure, referring to Figure 1(a) to Figure 1(h), Figure 2(a) to Figure 2(e), Figure 3(a) to Figure 3(d), Figure 4(a) to Figure 4(e), and Figure 5, the first depression 10 defined on the surface of the bottom electrode 300 away from the substrate 100 may be formed by etching the surface of the bottom electrode 300 away from the substrate 100. The etching may be performed by performing dry etching, wet etching, or dry and wet etching.

In an embodiment of the present disclosure, referring to Figure 6 to Figure 8, the first depression 10 defined on the surface of the bottom electrode 300 away from the substrate 100 may be formed through morphology transfer, similar to the second depression 20 formed on the surface of the piezoelectric layer 400 away from the substrate 100.

Specifically, in an embodiment of the present disclosure, referring to Figure 6 to Figure 8, a third depression 30 is defined on a surface of the structure formed by the acoustic reflection structure 200 and the substrate 100 towards the bottom electrode 300. The third depression 30 is filled by the bottom electrode 300. In the direction perpendicular to the plane where the substrate 100 is located, the bottom electrode 300 has an equal thickness. An orthographic projection of the third depression 30 on the plane where the substrate 100 is located covers the orthographic projection of the first depression 10 on the plane where the substrate 100 is located.

In the embodiment, the third depression 30 is defined on the surface of the structure formed by the acoustic reflection structure 200 and the substrate 100 towards the bottom electrode 300, the morphology of the third depression 30 is directly transferred to the surface of the bottom electrode 300 away from the substrate 100 in forming the bottom electrode 300 on a side of the structure formed by the acoustic reflection structure 200 and the substrate 100, and then the first depression 10 is formed on the surface of the bottom electrode 300 away from the substrate 100. The third depression 30 is filled by the bottom electrode 300, so that the morphology of the first depression 10 is directly transferred to the surface of the piezoelectric layer 400 away from the substrate 100 in forming the piezoelectric layer 400 on a side of the bottom electrode 300 away from the substrate 100, then the second depression 20 is formed on the surface of the piezoelectric layer 400 away from the substrate 100. The first depression 10 is filled by the piezoelectric layer 400. Thus, the morphology of the third depression 30 is transferred to the first depression 10 and then to the second depression 20 in the deposition of the bottom electrode 300 and the piezoelectric layer 400. That is, the first depression 10, the second depression 20 and the third depression 30 have similar morphology, and the positions of the first depression 10, the second depression 20 and the third depression 30 correspond to each other in the direction perpendicular to the plane where the substrate is located.

In the direction perpendicular to the plane where the substrate is located, the piezoelectric layer 400 has an equal thickness, and the bottom electrode 300 has an equal thickness. That is, the second depression 20 is formed on the surface of the piezoelectric layer 400 away from the substrate without physically damaging (such as, etching) the piezoelectric layer 400, and the first depression 10 is formed on the surface of the bottom electrode 300 away from the substrate without physically damaging (such as, etching) the bottom electrode 300. Therefore, in the bulk acoustic resonator according to the embodiment, the stress distribution of the piezoelectric layer 400 is uniform, achieving good device performance and yield.

In the embodiment, the morphology of the third depression 30 is transferred during the deposition of the bottom electrode 300, thus the first depression 10 is formed on the surface of the bottom electrode 300 away from the substrate 100. Therefore, the morphology of the first depression 10 is ideally identical to the morphology of the third depression 30. That is, an orthographic projection of the third depression 30 on the plane where the substrate is located completely coincides with the orthographic projection of the first depression 10 on the plane where the substrate is located. However, considering the actual process, the orthographic projection of the third depression 30 on the plane where the substrate is located may be greater than the orthographic projection of the first depression 30 on the plane where the substrate is located. That is, the orthographic projection of the third depression 30 on the plane where the substrate is located covers the orthographic projection of the first depression 10 on the plane where the substrate is located.

It should be noted that since the acoustic reflection structure 200 may be a cavity structure 210 or a distributed Bragg reflection structure 220, the processes of forming the third depression 30 on the surface of the structure formed by the acoustic reflection structure 200 and the substrate 100 towards the bottom electrode 300 are different when the acoustic reflection structure 200 is of different structures.

Specifically, in a case that the acoustic reflection structure 200 is the cavity structure 210 and the cavity structure 210 is embedded in the substrate 100, as shown in Figure 6 and Figure 7, the process of forming the third depression 30 on the surface of the structure formed by the acoustic reflection structure 200 and the substrate 100 toward the bottom electrode 300 includes the following steps.

Firstly, the substrate 100 is etched to form a groove.

Then, the groove of the substrate 100 is filled with a sacrificial material, and the sacrificial material is grinded and polished, so that the sacrificial material is flush with the surface of substrate 100. The sacrificial material may include phosphorous silicate glass (PSG) which, for example, includes 8% phosphorus and 92% silicon dioxide. The sacrificial material may be removed by etching with hydrofluoric acid.

Then, the third depression 30 may be formed by etching the substrate 100, as shown in Figure 6. Apparently, the third depression 30 may be formed by etching the sacrificial material filled in the groove of the substrate 100, as shown in Figure 7. Alternatively, the third depression 30 may be formed by etching the substrate 100 and the sacrificial material filled in the groove of the substrate 100. That is, the third depression 30 crosses the edge of the cavity structure 210.

Then, the third depression 30 is filled with a bottom electrode 300 in forming the bottom electrode 300 on a side of the substrate 100 and the sacrificial material. The morphology of the third depression 30 is transferred to the surface of the bottom electrode 300 away from the substrate 100, so that the first depression 10 is formed on the surface of the bottom electrode 300 away from the substrate 100, and the piezoelectric layer 400 and the top electrode 500 are sequentially formed on a side of the bottom electrode 300 away from the substrate 100. The morphology of the first depression 10 is transferred to the surface of the piezoelectric layer 400 away from the substrate 100, so that the second depression 20 is formed on the surface of the piezoelectric layer 400 away from the substrate 100.

Then, the sacrificial material in the groove of the substrate 100 is removed by using a corrosion solution. After the bottom electrode 300, the piezoelectric layer 400 and the top electrode 500 are sequentially formed, the piezoelectric layer 400 is etched to the cavity structure 210 to form a release hole to remove the sacrificial material in the cavity structure 210, so that the bottom electrode 300, the piezoelectric layer 400 and the top electrode 500 are suspended above the cavity structure 210, providing a reflection interface from the bottom electrode to the air.

It should be understood that in a case that the acoustic reflection structure 200 is the cavity structure and the cavity structure 210 is arranged above the substrate 100, the sacrificial material may be formed on the surface of the substrate 100, and then a side of the structure formed by the substrate 100 and the sacrificial material is etched to form the third depression 30. In subsequently depositing the bottom electrode 300, the morphology of the third depression 30 is transferred to the surface of the bottom electrode 300 away from the substrate 100 to form the first depression 10. In depositing the piezoelectric layer 400, the morphology of the first depression 10 is transferred to the surface of the piezoelectric layer 400 away from the substrate 100 to form the second depression. The top electrode 500 is formed finally. Then, the sacrificial material on the substrate 100 is removed by using a corrosion solution to form the cavity structure 210 between the bottom electrode 300 and the substrate 100.

In a case that the acoustic reflection structure 200 is the distributed Bragg reflection structure 220, it is illustrated by taking the distributed Bragg reflection structure embedded in the substrate 100 as an example. Referring to Figure 8, the process of forming the third depression 30 on the surface of the structure formed by the acoustic reflection structure 200 and the substrate 100 towards the bottom electrode 300 includes the following steps.

Firstly, the substrate 100 is etched to form a groove.

Then, the distributed Bragg reflection structure 220 is formed in the groove of the substrate 100. The structure formed by the substrate 100 and the distributed Bragg reflection structure 220 may be etched to form the third depression 30. That is, in the direction perpendicular to the plane where the substrate is located, the third depression 30 may be defined outside an edge of the distributed Bragg reflection structure 220, inside the edge of the distributed Bragg reflection structure 220, or across the edge of the distributed Bragg reflection structure 220. However, in order to reduce an impact on the distributed Bragg reflection structure, the third depression 30 is preferably defined outside the edge of the distributed Bragg reflection structure 220.

Then, the bottom electrode 300 is formed on a side of the substrate 100 and the distributed Bragg reflection structure 220, so that the third depression 30 is filled by the bottom electrode 300. The morphology of the third depression 30 is transferred to the surface of the bottom electrode 300 away from the substrate 100 to form the first depression 10 on the surface of the bottom electrode 300 away from the substrate 100. The piezoelectric layer 400 and the top electrode 500 are sequentially formed on a side of the bottom electrode 300 away from the substrate 100. The morphology of the first depression 10 is transferred to the surface of the piezoelectric layer 400 away from the substrate 100 to form the second depression 20 on the surface of the piezoelectric layer 400 away from the substrate 100, and finally the top electrode 500 is formed.

It should be understood that if the acoustic reflection structure 200 is the distributed Bragg reflection structure 220, the case in which the distributed Bragg reflection structure 220 is arranged above the substrate is similar to the case in which the distributed Bragg reflection structure is embedded in the substrate, and is not repeated herein.

In the embodiment, the third depression 30 defined on the surface of the structure formed by the acoustic reflection structure 200 and the substrate 100 facing the bottom electrode 300 may be formed by etching the surface of the structure formed by the acoustic reflection structure 200 and the substrate 100 facing the bottom electrode 300, or may be formed on the surface of the structure formed by the acoustic reflection structure 200 and the substrate 100 facing the bottom electrode 300 through morphology transfer, similar to the formation of the second depression 20 on the surface of the piezoelectric layer 400 away from the substrate 100, which is not limited in the present disclosure.

Since the first depression 10 is defined on the bottom electrode 300, the second depression 20 is defined on the piezoelectric layer 400, and the active region is an overlapping region of the acoustic reflection structure 200, the bottom electrode 300, the piezoelectric layer 400 and the top electrode 500 in the direction perpendicular to the surface where the substrate 100 is located, a position relationship between the first depression 10 and the second depression 20 and the active region depends on a position relationship between the first depression 10 and the second depression 20 and the top electrode 500 and a position relationship between the first depression 10 and the second depression 20 and the acoustic reflection structure 200. In addition, since the position of the first depression 10 corresponds to the position of the second depression 20 in the direction perpendicular to the plane where the substrate is located, a position relationship between the top electrode 500 and the second depression 20 represents the position relationship between the top electrode 500 and the first depression 10 and the second depression 20, and a position relationship between the acoustic reflection structure 200 and the second depression 20 represents the relationship between the acoustic reflection structure 200 and the first depression 10 and the second depression 20. Hereafter, a detail description is provided by taking the acoustic reflection structure as the cavity structure 210 embedded in the substrate 100 as an example.

It can be seen from the above descriptions that in practical applications, the orthographic projection of the acoustic reflection structure 200 on the plane where the substrate 100 is located usually covers the orthographic projection of the top electrode 500 on the plane where the substrate 100 is located, to avoid the parasitic oscillation caused by the contact between the piezoelectric layer 400 and the part of the top electrode 500 beyond the acoustic reflection structure 200. Therefore, on the basis of any one of the above embodiments, in an embodiment of the present disclosure, as shown in Figure 1(a) to Figure 1 (h), the edge of the acoustic reflection structure 200 is outside the edge of the top electrode 500 or coincides with the edge of the top electrode 500 in the direction perpendicular to the plane where the substrate 100 is located. The second depression 20 has a first side edge and a second side edge, the first side edge is opposite to the second side edge, and the second side edge is outside the first side edge. In the direction perpendicular to the plane where the substrate 100 is located, the first side edge of the second depression 20 is outside the edge of the top electrode 500 or coincides with the edge of the top electrode 500.

Specifically, in a case that the edge of the acoustic reflection structure 200 coincides with the edge of the top electrode 500 in the direction perpendicular to the plane where the substrate 100 is located, the active region is a region corresponding to the acoustic reflection structure 200 or a region corresponding to the top electrode 500. In this case, the first side edge of the second depression 20 may coincide with the edge of the top electrode 500 (or the edge of the acoustic reflection structure 200), as shown in Figure 1(a). Alternatively, the first side edge of the second depression 20 may be outside the edge of the top electrode 500 (or the edge of the acoustic reflection structure 200), that is, there is a distance between the first side edge of the second depression 20 and the edge of the top electrode 500, as shown in Figure 1(b).

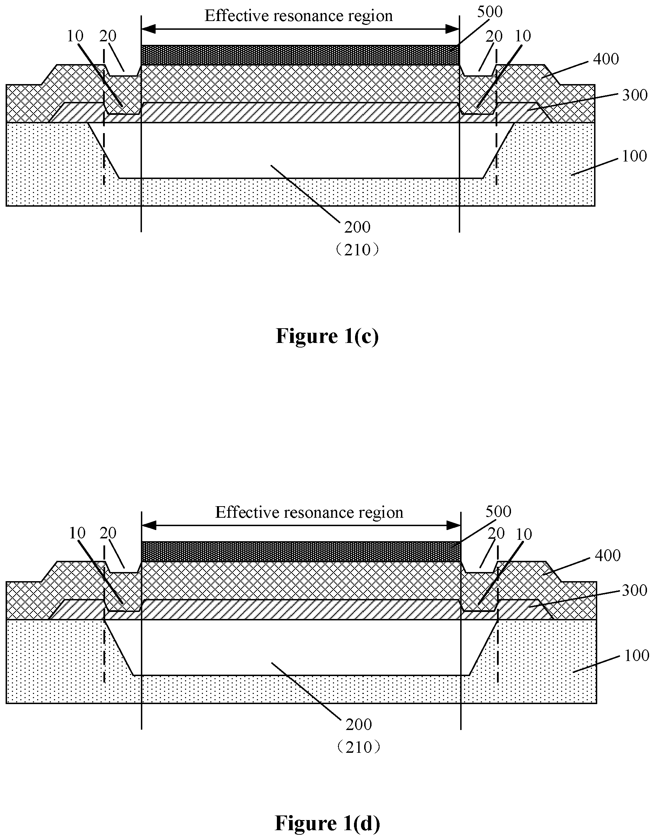

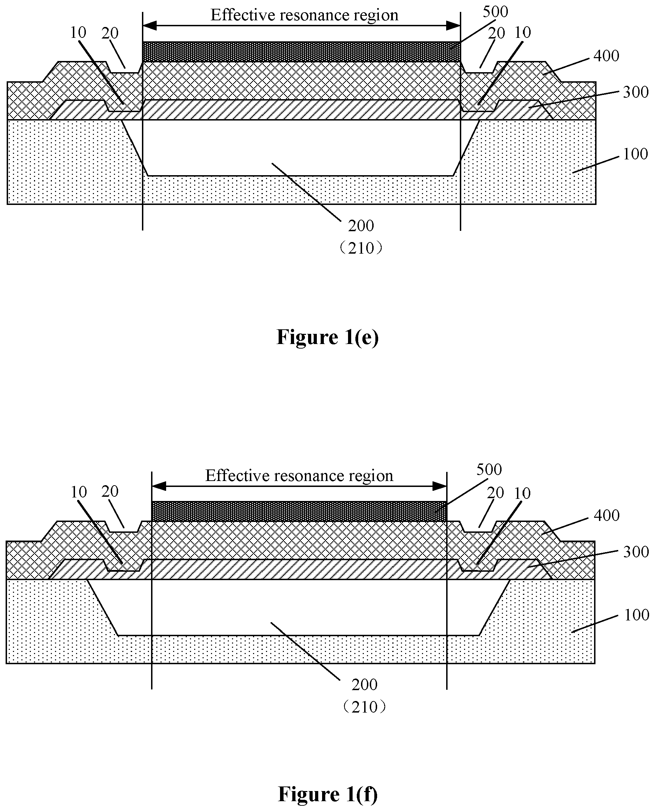

In a case that the edge of the acoustic reflection structure 200 is outside the edge of the top electrode 500 in the direction perpendicular to the plane where the substrate 100 is located, the active region is a region corresponding to the top electrode 500. In this case, if the first side edge of the second depression 20 coincides with the edge of the top electrode 500, the second side edge of the second depression 20 may be inside the edge of the acoustic reflection structure 200, as shown in Figure 1(c). Alternatively, the second side edge of the second depression 20 may coincide with the edge of the acoustic reflection structure 200, as shown in Figure 1(d). Alternatively, the second side edge of the second depression 20 may be outside the edge of the acoustic reflection structure 200. That is, the second depression 20 crosses the edge of the acoustic reflection structure 200, as shown in Figure 1(e).

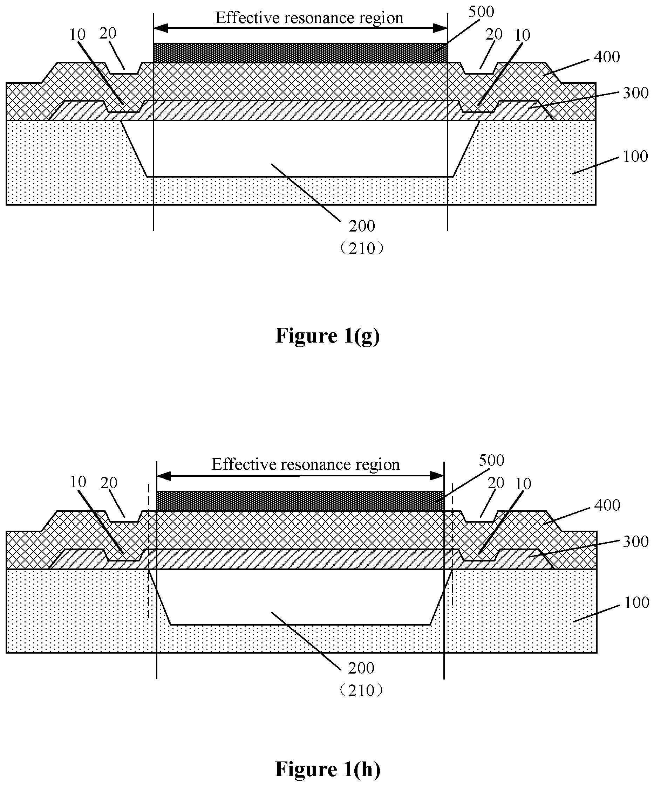

If the first side edge of the second depression 20 is outside the edge of the top electrode 500, that is, there is a distance between the first side edge of the second depression 20 and the edge of the top electrode 500, the second depression 20 may be inside the edge of the acoustic reflection structure 200 or coincide with the edge of the acoustic reflection structure 200, as shown in Figure 1(f). Alternatively, the second depression 20 may cross the edge of the acoustic reflection structure 200, then the first side edge of the second depression 20 is inside the edge of the acoustic reflection structure 200 and the second side edge of the second depression 20 is outside the edge of the acoustic reflection structure 200, as shown in Figure 1(g). Alternatively, the second depression 20 may be defined outside the edge of the acoustic reflection structure 200, thus the first side edge of the second depression 20 is arranged outside the edge of the acoustic reflection structure 200 or coincides with the edge of the acoustic reflection structure 200, as shown in Figure 1(h).

It should be noted that in the above embodiments, the orthographic projection of the acoustic reflection structure 200 on the plane where the substrate 100 is located is greater than or equal to the orthographic projection of the top electrode 500 on the plane where the substrate 100 is located. In addition, the orthographic projection of the second depression 20 on the plane where the substrate is located does not overlap with the orthographic projection of the top electrode 500 on the plane where the substrate 100 is located, or the orthographic projection of the second depression 20 on the plane where the substrate is located contacts with the orthographic projection of the top electrode 500 on the plane where the substrate 100 is located at a boundary. Therefore, the active region is defined by the edge of the top electrode 500.

In an embodiment of the present disclosure, as shown in Figure 2(a) to Figure 2(e), the edge of the acoustic reflection structure 200 is outside the edge of the top electrode 500 or coincides with the edge of the top electrode 500 in the direction perpendicular to the plane where the substrate 100 is located. The second depression 20 has a first side edge and a second side edge, the first side edge is opposite to the second side edge, and the second side edge is outside the first side edge. In the direction perpendicular to the plane where the substrate 100 is located, the second side edge of the second depression 20 is inside the edge of the top electrode 500 or coincides with the edge of the top electrode 500.

In a case that the edge of the acoustic reflection structure 200 is outside the edge of the top electrode 500 in the direction perpendicular to the plane where the substrate 100 is located, the second side edge of the second depression 20 may coincide with the edge of the top electrode 500, as shown in Figure 2(a). In this case, an overlapping region of the acoustic reflection structure 200, the bottom electrode 300, the piezoelectric layer 400 and the top electrode 500 located between first side edges of the second depression 20 is an active region. Alternatively, the second side edge of the second depression 20 may be inside the edge of the top electrode 500. That is, there is a distance between the second side edge of the second depression 20 and the edge of the top electrode 500, as shown in Figure 2(b). Then, both an overlapping region of the acoustic reflection structure 200, the bottom electrode 300, the piezoelectric layer 400 and the top electrode 500 located between first side edges of the second depression 20 and an overlapping region of the acoustic reflection structure 200, the bottom electrode 300, the piezoelectric layer 400 and the top electrode 500 located between the second side edge of the second depression 20 and the edge of the top electrode are active regions.

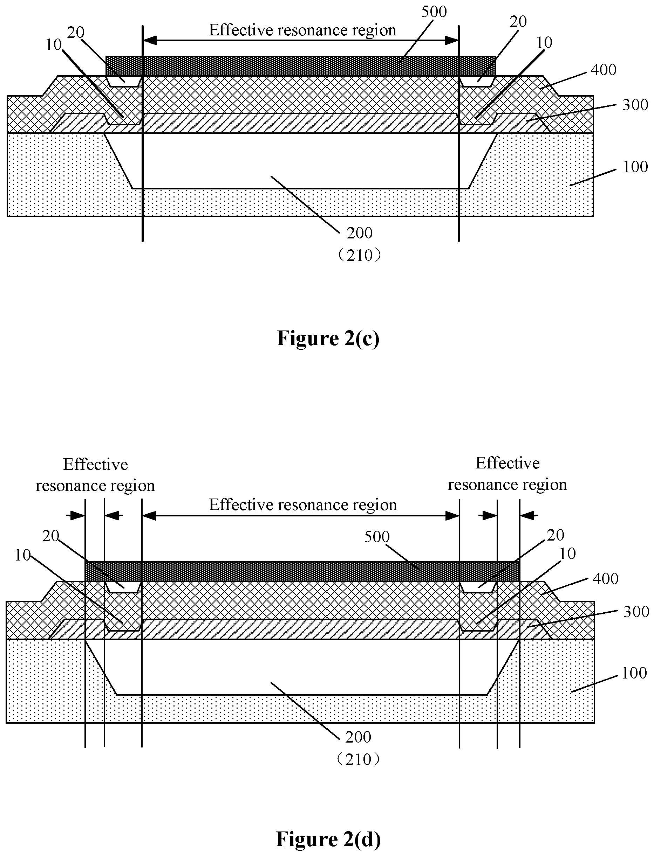

In a case that the edge of the acoustic reflection structure 200 coincides with the edge of the top electrode 500 in the direction perpendicular to the plane where the substrate 100 is located, the second side edge of the second depression 20 may coincide with the edge of the top electrode 500, as shown in Figure 2(c). In this case, an overlapping region of the acoustic reflection structure 200, the bottom electrode 300, the piezoelectric layer 400 and the top electrode 500 located between first side edges of the second depression 20 is an active region. Alternatively, the second side edge of the second depression 20 may be inside the edge of the top electrode 500. That is, there is distance between the second side edge of the second depression 20 and the edge of the top electrode 500, as shown in Figure 2(d). Then, both an overlapping region of the acoustic reflection structure 200, the bottom electrode 300, the piezoelectric layer 400 and the top electrode 500 located between first side edges of the second depression 20 and an overlapping region of the acoustic reflection structure 200, the bottom electrode 300, the piezoelectric layer 400 and the top electrode 500 located between the second side edge of the second depression 20 and the edge of the top electrode are active regions.

On the basis of any one of the above embodiments, in an embodiment of the present disclosure, as shown in Figure 2(a) to Figure 2(d), an extension direction of a part of the top electrode 500 corresponding to the second depression 20 is parallel to the plane where the substrate 100 is located in the direction perpendicular to the plane where the substrate 100 is located. That is, the part of the top electrode 500 corresponding to the second depression 20 is horizontal.

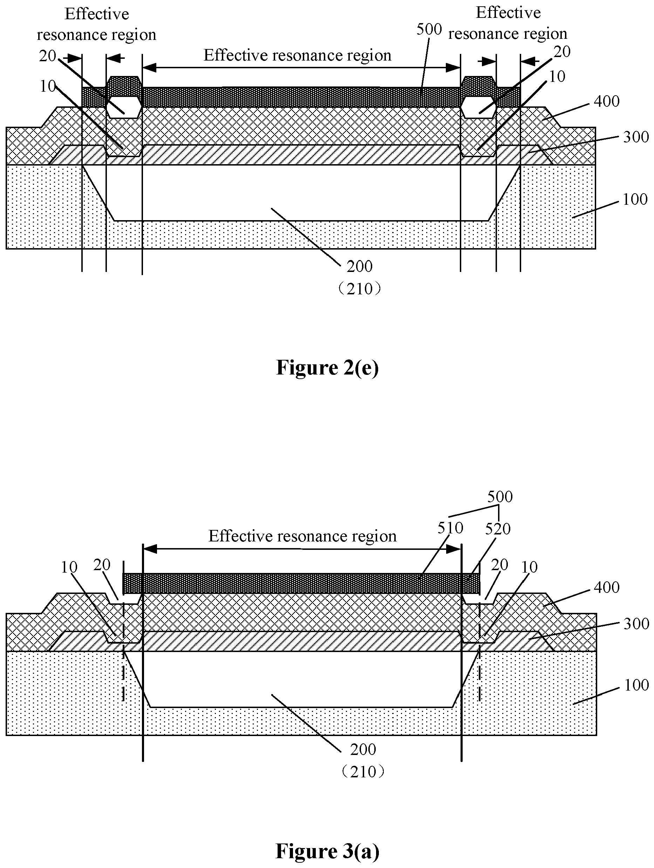

In another embodiment of the present disclosure, as shown in Figure 2(e), a part of the top electrode 500 corresponding to the second depression 20 protrudes away from the substrate 100 in the direction perpendicular to the plane where the substrate 100 is located. That is, the part of the top electrode 500 corresponding to the second depression 20 forms a structure similar to an arch bridge. Then, the second depression 20 has an arch bridge structure. With the second depression 20 having the arch bridge structure, an effect of reflecting the transverse waves is further improved, and the quality factor of the bulk acoustic wave resonator is improved.

In another embodiment of the present disclosure, as shown in Figure 3(a) to Figure 3(d), the edge of the acoustic reflection structure 200 is outside the edge of the top electrode 500 or coincides with the edge of the top electrode 500 in the direction perpendicular to the plane where the substrate 100 is located. The second depression 20 has a first side edge and a second side edge, the first side edge is opposite to the second side edge, and the second side edge is outside the first side edge. In the direction perpendicular to the plane where the substrate 100 is located, the first side edge of the second depression 20 is inside the edge of the top electrode 500, and the second side edge of the second depression 20 is outside the edge of the top electrode 500.

In the embodiment, the second depression 20 crosses the edge of the top electrode 500. In a case that the edge of the acoustic reflection structure 200 coincides with the edge of the top electrode 500 in the direction perpendicular to the plane where the substrate 100 is located, the case in which the second depression 20 crosses the edge of the top electrode 500 (or the edge of the acoustic reflection structure 200) is as shown in Figure 3(a). In this case, an overlapping region of the acoustic reflection structure 200, the bottom electrode 300, the piezoelectric layer 400 and the top electrode 500 located between first side edges of the second depression 20 is an active region.

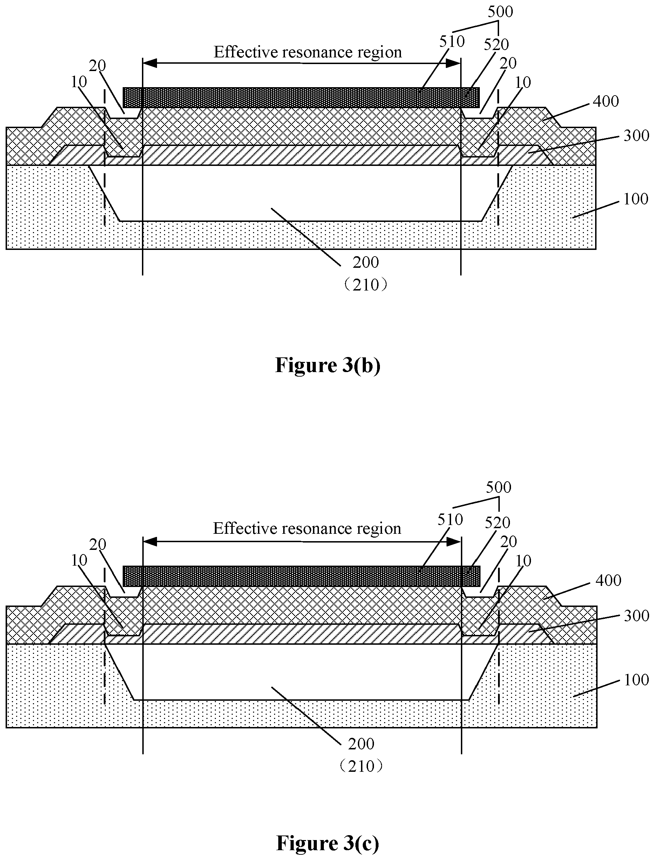

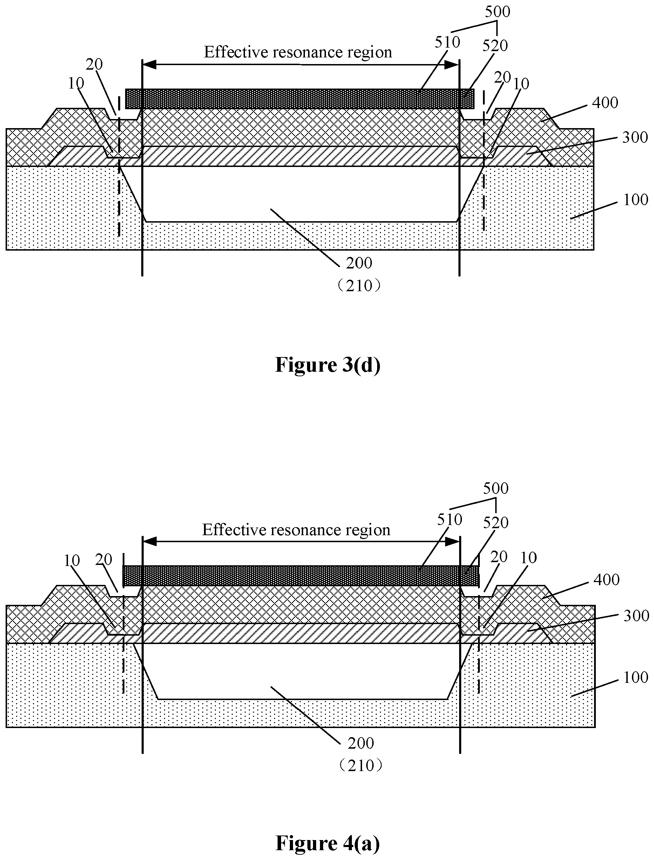

In a case that the edge of the acoustic reflection structure 200 is outside the edge of the top electrode 500 in the direction perpendicular to the plane where the substrate 100 is located, the second side edge of the second depression 20 may be inside the edge of the acoustic reflection structure 200, as shown in Figure 3(b). Alternatively, the second side edge of the second depression 20 may coincide with the edge of the acoustic reflection structure 200, as shown in Figure 3(c). Alternatively, the second side edge of the second depression 20 may be outside the edge of the acoustic reflection structure 200, as shown in Figure 3(d). In the above three cases, the overlapping region of the acoustic reflection structure 200, the bottom electrode 300, the piezoelectric layer 400 and the top electrode 500 located between first side edges of the second depression 20 is the active region.

In the above embodiments, in the direction perpendicular to the plane where the substrate 100 is located, the top electrode 500 is arranged inside the edge of the acoustic reflection structure 200. The edge of the top electrode 500 may coincide with the edge of the acoustic reflection structure 200, or the edge of the top electrode 500 may be inside the edge of the acoustic reflection structure 200. It is found that in a case that the second depression 20 crosses the edge of the top electrode 500, the edge of the top electrode 500 may be outside the edge of the acoustic reflection structure 200, then the part of the top electrode 500 beyond the edge of the acoustic reflection structure 200 may be suspended on the second depression 20, so that the piezoelectric layer 400 does not contact with the part of the top electrode 500 beyond the edge of the acoustic reflection structure 200 to generate parasitic oscillation. Therefore, as shown in Figure 4(a) to Figure 4(e), in another embodiment of the present disclosure, the edge of the top electrode 500 is outside the edge of the acoustic reflection structure 200 in the direction perpendicular to the plane where the substrate 100 is located. The second depression 20 has a first side edge and a second side edge, the first side edge is opposite to the second side edge, and the second side edge is outside the first side edge. In the direction perpendicular to the plane where the substrate 100 is located, the first side edge of the second depression 20 is inside the edge of the acoustic reflection structure 200 or coincides with the edge of the acoustic reflection structure 200, and the second side edge of the second depression 20 is outside the edge of the top electrode 500 or coincides with the edge of the top electrode 500.

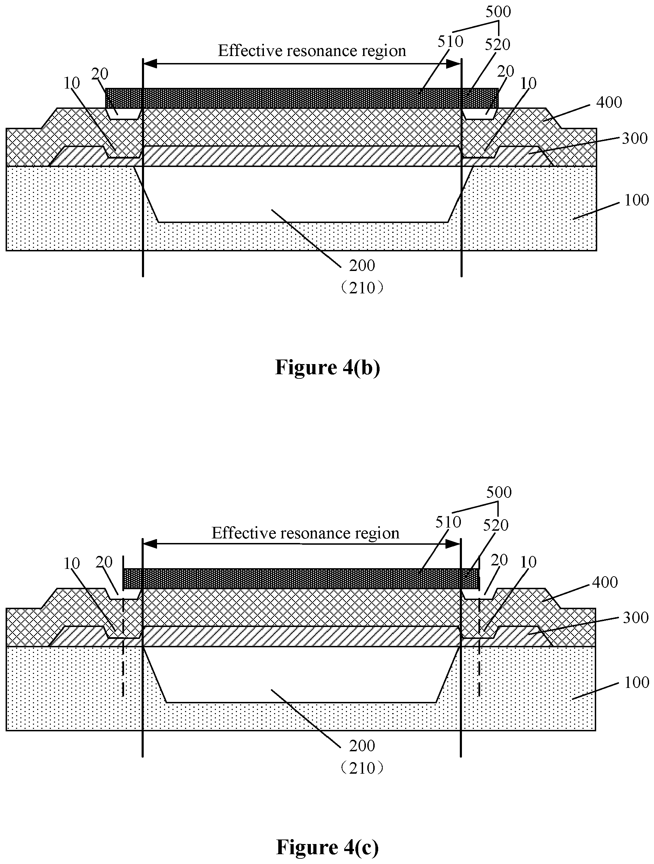

Specifically, in a case that the first side edge of the second depression 20 is inside the edge of the acoustic reflection structure 200 in the direction perpendicular to the plane where the substrate 100 is located, the second side edge of the second depression 20 may be outside the edge of the top electrode 500, as shown in Figure 4(a). Alternatively, the second side edge of the second depression 20 may coincide with the edge of the top electrode 500, as shown in Figure 4(b). In the above both cases, an overlapping region of the acoustic reflection structure 200, the bottom electrode 300, the piezoelectric layer 400 and the top electrode 500 located between first side edges of the second depression 20 is an active region.

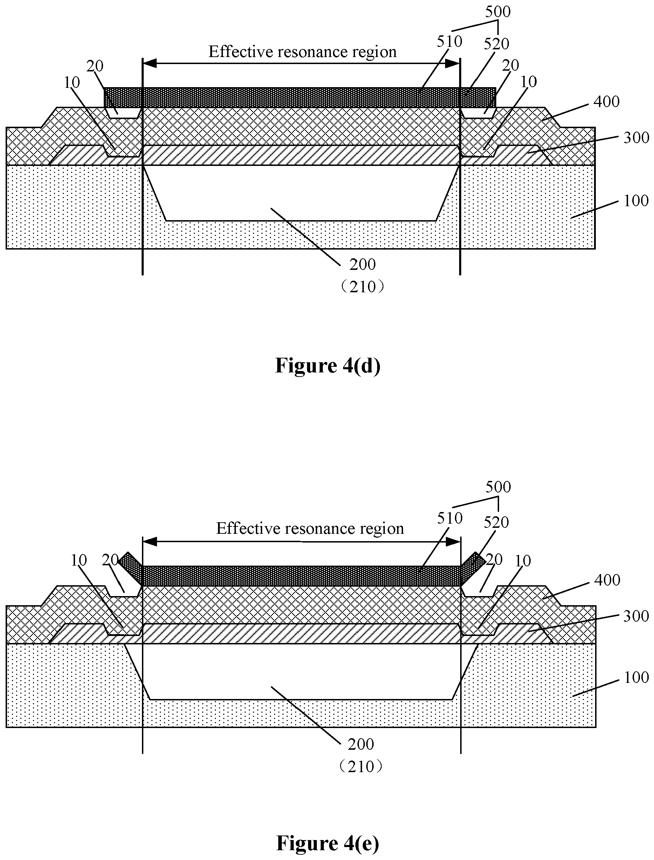

In a case that the first side edge of the second depression 20 coincides with the an inner side of the edge of the acoustic reflection structure 200 in the direction perpendicular to the plane where the substrate 100 is located, the second side edge of the second depression 20 may be outside the edge of the top electrode 500, as shown in Figure 4(c). Alternatively, the second side edge of the second depression 20 may coincide with the edge of the top electrode 500, as shown in Figure 4(d). In the above both cases, an overlapping region of the acoustic reflection structure 200, the bottom electrode 300, the piezoelectric layer 400 and the top electrode 500 located between first side edges of the second depression 20 is an active region.

It should be noted that in the above embodiments, the edge of the top electrode 500 exceeds the edge of the acoustic reflection structure 200. However, on the outside of the edge of the acoustic reflection structure 200, the top electrode 500 is separated from the piezoelectric layer 400 by the second depression 20, so that the top electrode 500 does not contact with the piezoelectric layer 400 on the outside of the edge of the acoustic reflection structure 200. Therefore, no parasitic resonance is generated.

On the basis of the above embodiments, the top electrode 500 includes a first part 510 and a second part 520. The first part 510 extends in a direction parallel to the plane where the substrate 100 is located, and the first part 100 contacts with the surface of the piezoelectric layer 400 away from the substrate 100. The second part 520 is suspended above the second depression 20. That is, the second part 520 of the top electrode 500 forms a "hat brim" structure.

In an embodiment of the present disclosure, as shown in Figure 3(a) to Figure 3(d) and Figure 4(a) to Figure 4(d), the second part 520 of the top electrode 500 extends in a direction parallel to the plane of the substrate 100. That is, in the embodiment, the first part 510 and the second part 520 of the top electrode extend in the same direction which is parallel to the plane where the substrate is located, and are horizontal.

In another embodiment of the present disclosure, as shown in Figure 4(e), an angle between the extension direction of the second part 520 of the top electrode 500 and the extension direction of the first part 510 of the top electrode 500 is greater than 0 degree and less than 90 degrees. That is, in the embodiment, the second part 520 of the top electrode 500, which is above the second depression 200, tilts upwards away from the substrate 100. Thus, the edge of the acoustic reflection structure 200 may be located inside the edge of the top electrode 500 or outside the edge of the top electrode 500, or coincide with the edge of the top electrode 500.

On the basis of the above embodiments, in an embodiment of the present disclosure, as shown in Figure 3(a) to Figure 3(d), Figure 4(a) and Figure 4 (c), the first side edge of the second depression 20 is located inside the edge of the top electrode 500, and the second side edge of the second depression 20 is located outside the edge of the top electrode 500. That is, the second depression 20 crosses the edge of the top electrode 500.

Thus, the extension direction of the second part 520 of the top electrode 500 is parallel to the plane where the substrate 100 is located, and an end face of the second part 520 of the top electrode 500 away from the first part 510 is perpendicular to the plane where the substrate 100 is located. That is, a side wall of the top electrode 500 suspended above the second depression 20 is vertical. The vertical side wall may be formed by performing dry etching. In performing dry etching, since the side of the top electrode 500 is separated from the surface of the piezoelectric layer 400 away from the substrate by the second depression 20 filled with air or other medium, the piezoelectric layer 400 is not to be damaged even if slightly excessive etching is performed, thereby protecting the piezoelectric consistency of the piezoelectric layer 400.

Based on the above embodiments, it can be seen that the second depression 20 may be defined inside the edge of the top electrode 500, across the edge of the top electrode 500, or outside the edge of the top electrode 500. The top electrode 500 is usually in a polygon shape, such as in a pentagon shape. Therefore, as shown in Figure 18 to Figure 20, the top electrode 500 includes multiple side edges, and the second depression 20 is defined corresponding to at least one of the side edges of the top electrode 500 in the direction perpendicular to the plane where the substrate is located.

In an embodiment of the present disclosure, the second depression 20 is defined corresponding to one of the side edges of the top electrode 500 in the direction perpendicular to the plane where the substrate is located.

In another embodiment of the present disclosure, the second depression 20 is defined corresponding to multiple of the side edges of the top electrode 500 in the direction perpendicular to the plane where the substrate is located.

In another embodiment of the present disclosure, the second depression 20 is defined corresponding to all the side edges of the top electrode 500 in the direction perpendicular to the plane where the substrate is located. In the present disclosure, whether the second depression 20 is defined corresponding to one of the side edges of the top electrode 500 or multiple of the side edges of the top electrode 500 is not limited, which depends on actual situations.

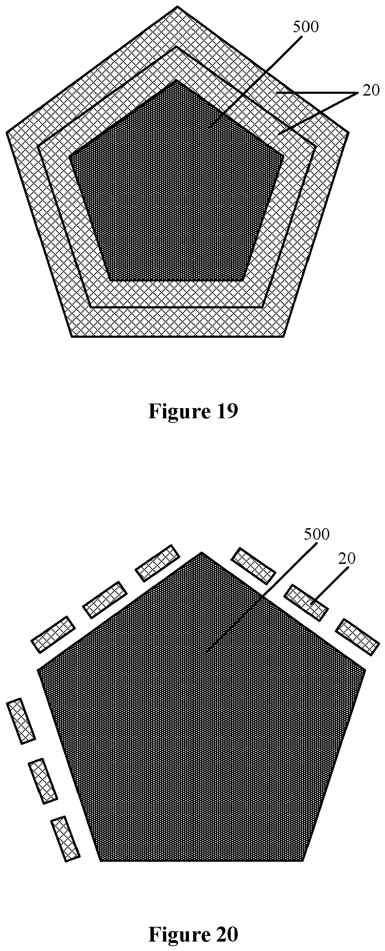

On the basis of the above embodiments, in an embodiment of the present disclosure, as shown in Figure 18 and Figure 19, the second depression 20 may include at least one continuous groove corresponding to the edges of the top electrode 500. Specifically, in an embodiment of the present disclosure, the second depression 20 may be a continuous groove surrounding the edges of the top electrode 500 (as shown in Figure 18). For each of the edges of the top electrode 500, a part of the continuous groove corresponding to the edge may be regular or irregular, and the part of the continuous groove corresponding to the edge may have an equal or a different length, width and depth, which are determined according to actual situations.

Specifically, in another embodiment of the present disclosure, the second depression 20 may include multiple continuous grooves surrounding the edges of the top electrode 500 (as shown in Figure 19). The multiple continuous grooves may have equal or different shapes, lengths, widths and depths, which is determined according to actual situations.

In another embodiment of the present disclosure, as shown in Figure 20, the second depression 20 may include multiple point-shaped grooves corresponding to at least one of the edges of the top electrode 500. The multiple point-shaped grooves may have equal or different shapes, lengths, widths and depths, which is determined according to actual situations.

In another embodiment of the present disclosure, based on Figure 18 to Figure 20, the second depression 20 may include at least one continuous groove corresponding to the edges of the top electrode 500 and multiple point-shaped grooves corresponding to at least one of the edges of the top electrode 500, which is determined according to actual situations.

It should be noted that in the above embodiments, in the direction perpendicular to the plane where the substrate 100 is located, the second depression 20 may be defined outside the edges of the top electrode 500, cross the edges of the top electrode 500, or inside the edges of the top electrode 500. That is, a distance between the second depression 20 and an edge of the top electrode 500 may be greater than or equal to 0. The distances between the second depression 20 and the edges of the top electrode 500 may be identical or different, which is determined according to actual situations.

For example, a distance between the second depression 20 and one edge of the top electrode 500 is greater than 0, and a distance between the second depression 20 and another edge of the top electrode 500 is equal to 0.

In an embodiment, distances between the second depression 20 and the edges of the top electrode 500 range from 0 µ m to 10 µ m, which is determined according to actual situations.

On the basis of any one of the above embodiments, in an embodiment of the present disclosure, the acoustic reflection structure 200 may be in a rectangular shape. It is easy to identify the edge of the acoustic reflection structure 200 in the direction perpendicular to the plane where the substrate is located. As the described position relationship between the second depression 20 and the acoustic reflection structure 200 in the above embodiments, the second depression 20 may be defined outside the edge of the acoustic reflection structure 200, inside the edge the edge of the acoustic reflection structure 200, or across the edge of the acoustic reflection structure 200.

In another embodiment of the present disclosure, the acoustic reflection structure 200 may be in an inverted trapezoid shape. In the direction perpendicular to the plane where the substrate is located, an edge of the acoustic reflection structure 200 may corresponds to the upper bottom of the inverted trapezoid. As the described position relationship between the second depression 20 and the acoustic reflection structure 200 in the above embodiments, the second depression 20 may be defined outside the edge of the acoustic reflection structure 200, inside the edge the edge of the acoustic reflection structure 200, or across the edge of the acoustic reflection structure 200.

A method for manufacturing a bulk acoustic resonator is further provided according to an embodiment of the present disclosure. Referring to Figure 1(a) to Figure 1(h), Figure 2(a) to Figure 2(e), Figure 3(a) to Figure 3(d), Figure 4(a) to Figure 4(e), and Figure 5 to Figure 8, the method includes the following steps S100 to S400.

In step S100, a substrate 100 is obtained.

The substrate 100 is preferably a high-impedance Si substrate. Alternatively, the substrate 100 may other substrates, such as a silicon dioxide (SiO2) substrate, a gallium arsenide (GaAs) substrate, a gallium nitride (GaN) substrate, a glass substrate, or a ceramic substrate.

In step S200, a bottom electrode 300 is arranged on the substrate 100, a first depression 10 is defined on a surface of the bottom electrode 300 away from the substrate 100, and an acoustic reflection structure 200 or a sacrificial layer is arranged between the bottom electrode 300 and the substrate 100.

An edge of the bottom electrode 10 is connected to outside to provide an electrical signal for the bottom electrode.

In an embodiment, the acoustic reflection structure 200 may be a cavity structure 210 or a distributed Bragg reflection structure 220.

Specifically, in a case that the acoustic reflection structure 200 is the cavity structure 210, the cavity structure 210 may be arranged on the substrate 100. In this case, a sacrificial material is required to be deposited on the substrate 100 to form a sacrificial layer. Then, a bottom electrode 300 is formed on the sacrificial material and the substrate 100, so that the sacrificial material is filled between the bottom electrode 300 and the substrate 100. After a piezoelectric layer 400 and a top electrode 500 are formed sequentially on a side of the bottom electrode 300 away from the substrate 100, the piezoelectric layer 400 is etched to the sacrificial material to form a release hole. The sacrificial material is removed by using a corrosion solution to form the cavity structure 210 between the bottom electrode 300 and the substrate 100, so that the bottom electrode 300, the piezoelectric layer 400 and the top electrode 500 are suspended above the cavity 210, providing a reflection interface between the bottom electrode and the air.

In a case that the acoustic reflection structure 200 is the cavity structure 210, the cavity structure 210 may be embedded in the substrate. In this case, it is required to etch the substrate 100 to form a groove. Then, the groove on the substrate 100 is filled with a sacrificial material to form a sacrificial layer. The sacrificial material is grinded and polished, so that the sacrificial material is flush with the plane of the substrate 100. A bottom electrode 300, a piezoelectric layer 400, and a top electrode 500 are formed sequentially on a side of the substrate 100 and the sacrificial material. Then, the piezoelectric layer 400 is etched to the sacrificial material to form a release hole to remove the sacrificial material to form the cavity structure 210 between the bottom electrode 300 and the substrate, so that the bottom electrode 300, the piezoelectric layer 400 and the top electrode 500 are suspended above the cavity structure 210, providing a reflection interface between the bottom electrode and the air.

In a case that the acoustic reflection structure 200 is the distributed Bragg reflection structure 220, the Bragg reflection structure 220 may be arranged on the substrate. Then, the distributed Bragg reflection structure 220 is directly formed on the substrate 100. Alternatively, the distributed Bragg reflection structure 220 may be embedded in the substrate 100. Then, it is required to etch the substrate 100 to form a groove, and the distributed Bragg reflection structure 220 is formed in the groove of the substrate 100. No matter the Bragg reflection structure 220 is arranged on the substrate 100 or is embedded in the substrate 100, the bottom electrode 300, the piezoelectric layer 400 and the top electrode 500 may be formed sequentially on the substrate 100 and the distributed Bragg reflection structure 220.

In step S300, a piezoelectric layer 400 is arranged on a side of the bottom electrode 300 away from the substrate 100. The first depression 10 is filled by the piezoelectric layer 400. In forming the piezoelectric layer 400, a morphology of the first depression 10 is transferred to a surface of the piezoelectric layer 400 away from the substrate 100 to form a second depression 20 on the surface of the piezoelectric layer 400 away from the substrate 100. In the direction perpendicular to the plane where the substrate is located, the piezoelectric layer 400 has an equal thickness. An orthographic projection of the first depression 10 on the plane where the substrate is located covers an orthographic projection of the second depression 20 on the plane where the substrate is located.

In step S400, a top electrode 500 is arranged on a side of the piezoelectric layer 400 away from the substrate.

An edge of the top electrode 500 is connected to the outside to provide an electrical signal for the top electrode.

It should be noted that the top electrode 500 and the bottom electrode 300 preferably have same of different materials, thicknesses and shapes. The bottom electrode 300 may be greater than the top electrode 500 in area. The materials of the top electrode 500 and the bottom electrode 300 are preferably molybdenum (Mo). Alternatively, the materials of the top electrode 500 and the bottom electrode 300 may be other material, such as gold (Au), ruthenium (Ru), aluminum (Al), platinum (Pt), titanium (Ti), tungsten (W), palladium (Pd), chromium (Cr), and nickel (Ni). The material of the piezoelectric layer 400 is preferably aluminum nitride (AlN). Alternatively, the materials of the piezoelectric layer 400 may be zinc oxide (ZnO), zinc sulfide (ZnS), cadmium sulfide (CdS), lead titanate [PT](PbTiO3), lead zirconate titanate [PZT](Pb(Zr, Ti)O3), lithium tantalate (LiTaO3) or other members of the lead zirconate lanthanum series.

It should be noted that the bottom electrode 300 may be a single-layer electrode or a composite electrode including two or more layers. Similarly, the top electrode 500 may be a single-layer electrode or a composite electrode including two or more layers. The top electrode 500 is preferably a single-layer electrode. The piezoelectric layer 400 may be doped with other materials, such as scandium, yttrium, magnesium, titanium, lanthanum, cerium, praseodymium, neodymium, promethium, samarium, europium, gadolinium, terbium, dysprosium, holmium, erbium, thulium, ytterbium, and lutetium, to change a piezoelectric property.

It should be noted that the second depression 20 may be filled with air or other dielectric materials with low acoustic impedance, low dielectric constant or high insulation. A dielectric material with low acoustic impedance may be filled in the second depression 20 after the sacrificial material in the second depression is removed. Alternatively, the dielectric material, instead of the sacrificial material, is directly filled in the second depression, and then the material filled in the second depression is not removed.

In the embodiment, the first depression 10 is formed on the surface of the bottom electrode 300 away from the substrate 100, and the second depression 20 is formed on the surface of the piezoelectric layer 400 away from the substrate 100 through morphology transfer. In this way, the second depression 20 is formed on the surface of the piezoelectric layer 400 away from the substrate 100 without physically damaging the piezoelectric layer 400, solving the problem of non-uniform stress distribution of the piezoelectric layer 400 caused by forming a depression on the piezoelectric layer 400 by performing physical damage such as etching the piezoelectric layer 400 according to the conventional technology, improving uniformity of the stress distribution of the piezoelectric layer 400, and improving the performance and yield of the bulk acoustic resonator. In addition, the first depression 10 and the second depression 20 may be arranged near the edge of the active region, suppressing transverse wave resonance and reducing the leakage of the transverse wave. That is, the loss of acoustic energy is reduced, and the proportion of the transverse wave in the acoustic energy is reduced, thereby improving the quality factor of the bulk acoustic resonator.

On the basis of the above embodiments, in an embodiment of the present disclosure, the first depression 10 on the surface of the bottom electrode 300 away from the substrate 100 may be defined by etching the surface of the bottom electrode 300 away from the substrate 100. The etching may include dry etching, wet etching, or dry and wet etching.

In another embodiment of the present disclosure, before the bottom electrode is arranged, the method further includes the following steps S210 and S220.

In step S210, the acoustic reflection structure 200 or the sacrificial layer 210 is arranged. The acoustic reflection structure 200 or the sacrificial layer 210 is arranged on the substrate 100 or is embedded in the substrate 100.

In step S220, a third depression 30 is defined on a side of a structure formed by the acoustic reflection structure 200 and the substrate 100 or on a side of a structure formed by the sacrificial layer 210 and the substrate 100.

Based on the above descriptions, it is known that the acoustic reflection structure 200 may be a cavity structure 210 or a distributed Bragg reflection structure 220. In a case that the acoustic reflection structure 200 is the cavity structure 210, a sacrificial material is filled in a region where the cavity structure is to be arranged, and then the sacrificial material is removed after the bottom electrode 300, the piezoelectric layer 400, and the top electrode 500 are formed. Therefore, the third depression 30 may be defined by etching the substrate 100, or by etching the sacrificial material, or by etching both the substrate 100 and the sacrificial material. Then, the bottom electrode 300 and the piezoelectric layer 400 are sequentially formed based on deposition on the substrate 100, the sacrificial material and the third depression 30. In the deposition of the bottom electrode 300 and the piezoelectric layer 400, the morphology of the third depression 30 is transferred to the surface of the bottom electrode 300 away from the substrate to form the first depression 10, and is transferred to the surface of the piezoelectric layer 400 away from the substrate to form the second depression 20. Even if the sacrificial material is subsequently removed, the first depression 10 on the surface of the bottom electrode 300 away from the substrate and the second depression 20 on the surface of the piezoelectric layer 400 away from the substrate are not affected. In a case that the acoustic reflection structure 200 is the distributed Bragg reflection structure 220, it is unnecessary to remove the sacrificial material.

In the embodiment, the bottom electrode 300 is arranged by performing the following operations. The bottom electrode 300 is arranged on the side of the structure formed by the acoustic reflection structure 200 and the substrate 100 or on the structure formed by the sacrificial layer 210 and the substrate 100. The third depression is filled by the bottom electrode 300. In arranging the bottom electrode 300, a morphology of the third depression 30 is transferred to the surface of the bottom electrode 300 away from the substrate to form the first depression on the surface of the bottom electrode 300 away from the substrate. In the direction perpendicular to the plane where the substrate is located, the bottom electrode 300 has an equal thickness. An orthographic projection of the third depression 30 on the plane where the substrate is located covers the orthographic projection of the first depression 10 on the plane where the substrate is located.

In the embodiment, in the direction perpendicular to the plane where the substrate is located, the piezoelectric layer 400 has an equal thickness, and the bottom electrode 300 has an equal thickness. That is, the second depression 20 is defined on the surface of the piezoelectric layer 400 away from the substrate without performing physical damage, such as etching, on the piezoelectric layer 400, and the first depression 10 is defined on the surface of the bottom electrode 300 away from the substrate without performing physical damage, such as etching, on the bottom electrode 300. Therefore, in the bulk acoustic resonator according to the embodiment, the stress distribution of the piezoelectric layer 400 is uniform, and the device has good performance and yield.

A filter is further provided according to an embodiment of the present disclosure. The filter includes the bulk acoustic resonator according to any one of the above embodiments. The bulk acoustic resonator has been described in detail in the above embodiments, and is not repeated herein.

An electronic device is further provided according to an embodiment of the present disclosure. The electronic device includes the filter described above or the bulk acoustic resonator according to any one of the above embodiments. The bulk acoustic resonator is described in detail in the above embodiments, and is not repeated herein.

The embodiments of the present disclosure are described in a combination of a parallel manner and a progressive manner. Each embodiment focuses on differences from other embodiment, and the same or similar parts between the various embodiments may be referred to each other.

Features described in the embodiments of the present disclosure may be replaced or combined with each other. The above illustration of the disclosed embodiments enables those skilled in the art to implement or practice the present disclosure. Many changes to these embodiments are apparent for those skilled in the art, and general principles defined herein can be implemented in other embodiments without departing the spirit or scope of the present disclosure. Therefore, the present disclosure is not limited to the embodiments disclosed herein, but is to conform to the widest scope consistent with principles and novel features disclosed herein.

## Claims

1. A bulk acoustic resonator, comprising: a substrate, an acoustic reflection structure, a bottom electrode, a piezoelectric layer, and a top electrode, wherein
the acoustic reflection structure is arranged on the substrate or is embedded in the substrate; and
the bottom electrode, the piezoelectric layer and the top electrode are sequentially arranged on a side of a structure formed by the acoustic reflection structure and the substrate, a first depression is defined on a surface of the bottom electrode away from the substrate, the first depression is filled by the piezoelectric layer, a second depression is defined on a surface of the piezoelectric layer away from the substrate, the piezoelectric layer has an equal thickness in a direction perpendicular to a plane where the substrate is located, and an orthographic projection of the first depression on the plane where the substrate is located is configured to cover an orthographic projection of the second depression on the plane where the substrate is located.

2. The bulk acoustic resonator according to claim 1, wherein
a third depression is defined on a surface of the structure formed by the acoustic reflection structure and the substrate towards the bottom electrode, the third depression is filled by the bottom electrode, the bottom electrode has an equal thickness in the direction perpendicular to the plane where the substrate is located, and an orthographic projection of the third depression on the plane where the substrate is located is configured to cover the orthographic projection of the first depression on the plane where the substrate is located.

3. The bulk acoustic resonator according to claim 1, wherein
in the direction perpendicular to the plane where the substrate is located, an edge of the acoustic reflection structure is arranged to be outside an edge of the top electrode or to coincide with the edge of the top electrode;
the second depression comprises a first side edge and a second side edge, the first side edge is opposite to the second side edge, and the second side edge is arranged outside the first side edge; and
in the direction perpendicular to the plane where the substrate is located, the first side edge of the second depression is arranged to be outside the edge of the top electrode or to coincide with the edge of the top electrode.

4. The bulk acoustic resonator according to claim 1, wherein
in the direction perpendicular to the plane where the substrate is located, an edge of the acoustic reflection structure is arranged to be outside an edge of the top electrode or to coincide with the edge of the top electrode;
the second depression comprises a first side edge and a second side edge, the first side edge is opposite to the second side edge, and the second side edge is arranged outside the first side edge; and
in the direction perpendicular to the plane where the substrate is located, the second side edge of the second depression is arranged to be inside the edge of the top electrode or to coincide with the edge of the top electrode.

5. The bulk acoustic resonator according to claim 4, wherein
in the direction perpendicular to the plane where the substrate is located, a part of the top electrode corresponding to the second depression is arranged to extend in a direction parallel to the plane where the substrate is located; or
in the direction perpendicular to the plane where the substrate is located, a part of the top electrode corresponding to the second depression is arranged to protrude away from the substrate.

6. The bulk acoustic resonator according to claim 1, wherein
in the direction perpendicular to the plane where the substrate is located, an edge of the acoustic reflection structure is arranged to be outside an edge of the top electrode or to coincide with the edge of the top electrode;
the second depression comprises a first side edge and a second side edge, the first side edge is opposite to the second side edge, and the second side edge is arranged to be outside the first side edge; and
in the direction perpendicular to the plane where the substrate is located, the first side edge of the second depression is arranged to be inside the edge of the top electrode, and the second side edge of the second depression is arranged to be outside the edge of the top electrode.

7. The bulk acoustic resonator according to claim 1, wherein
in the direction perpendicular to the plane where the substrate is located, an edge of the top electrode is arranged to be outside an edge of the acoustic reflection structure;
the second depression comprises a first side edge and a second side edge, the first side edge is opposite to the second side edge, and the second side edge is arranged to be outside the first side edge; and
in the direction perpendicular to the plane where the substrate is located, the first side edge of the second depression is arranged to be inside the edge of the acoustic reflection structure or to coincide with the edge of the acoustic reflection structure, and the second side edge of the second depression is arranged to be outside the edge of the top electrode or to coincide with the edge of the top electrode.

8. The bulk acoustic resonator according to claim 6 or 7, wherein
the top electrode comprises a first part and a second part, the first part is arranged to extend in a direction parallel to the plane where the substrate is located, the first part is arranged to contact with the surface of the piezoelectric layer away from the substrate, and the second part is arranged to be suspended above the second depression; wherein
the second part is arranged to extend in a direction parallel to the plane where the substrate is located; or
the second part is arranged to extend in a direction with an angle greater than 0° and less than 90° from the direction in which the first part extends.

9. The bulk acoustic resonator according to claim 8, wherein
the first side edge of the second depression is arranged to be inside the edge of the top electrode, and the second side edge of the second depression is arranged to be outside the edge of the top electrode; and
the second part is arranged to extend in a direction parallel to the plane where the substrate is located, and an end face of the second part away from the first part is arranged to be perpendicular to the plane where the substrate is located.

10. The bulk acoustic resonator according to claim 1, wherein the top electrode comprises a plurality of edges, and in the direction perpendicular to the plane where the substrate is located, the second depression is arranged to correspond to at least one of the edges of the top electrode.

11. The bulk acoustic resonator according to claim 10, wherein
the second depression comprises at least one continuous groove corresponding to the edges of the top electrode; and/or
the second depression comprises a plurality of point-shaped grooves corresponding to at least one of the edges of the top electrode.

12. The bulk acoustic resonator according to claim 1, wherein the acoustic reflection structure is configured to be a cavity structure or a distributed Bragg reflection structure.

13. The bulk acoustic resonator according to claim 1, wherein each of the first depression and the second depression is configured to be in an inverted trapezoid shape, in an inverted triangle shape, in a square shape, or in an irregular shape.

14. The bulk acoustic resonator according to claim 1, wherein the second depression is filled with a filling medium, and the filling medium comprises air, phosphorus-doped silicon dioxide, carbon-doped silicon dioxide, dielectric resin, or benzocyclobutene.

15. The bulk acoustic resonator according to claim 1, wherein in the direction perpendicular to the plane where the substrate is located, the first depression has a depth less than or equal to a thickness of the bottom electrode.

16. The bulk acoustic resonator according to claim 1, wherein an end of the bottom electrode is vertical, inclined, in a stepped shape, or in an arc shape.

17. A method for manufacturing a bulk acoustic resonator, comprising:
obtaining a substrate;
arranging a bottom electrode on the substrate, defining a first depression on a surface of the bottom electrode away from the substrate, and arranging an acoustic reflection structure or a sacrificial layer between the bottom electrode and the substrate;
arranging a piezoelectric layer on a side of the bottom electrode away from the substrate, wherein the first depression is filled by the piezoelectric layer, a morphology of the first depression is transferred to a surface of the piezoelectric layer away from the substrate in forming the piezoelectric layer to form a second depression on the surface of the piezoelectric layer away from the substrate, the piezoelectric layer has an equal thickness in a direction perpendicular to a plane where the substrate is located, and an orthographic projection of the first depression on the plane where the substrate is located covers an orthographic projection of the second depression on the plane where the substrate is located; and
arranging a top electrode on a side of the piezoelectric layer away from the substrate.

18. The method according to claim 17, wherein before arranging the bottom electrode, the method further comprises:
arranging the acoustic reflection structure or the sacrificial layer, wherein the acoustic reflection structure or the sacrificial layer is arranged on the substrate or is embedded in the substrate; and
defining a third depression on a side of a structure formed by the acoustic reflection structure and the substrate or on a side of a structure formed by the sacrificial layer and the substrate; wherein
the arranging a bottom electrode comprises:
arranging the bottom electrode on the side of the structure formed by the acoustic reflection structure and the substrate or on the side of the structure formed by the sacrificial layer and the substrate, filling the third depression by the bottom electrode, transferring a morphology of the third depression to the surface of the bottom electrode away from the substrate to form the first depression on the surface of the bottom electrode away from the substrate, configuring the bottom electrode to have an equal thickness in the direction perpendicular to the plane where the substrate is located, and configuring an orthographic projection of the third depression on the plane where the substrate is located to cover the orthographic projection of the first depression on the plane where the substrate is located.

19. A filter, comprising the bulk acoustic resonator according to any one of claims 1 to 16.

20. An electronic device, comprising the filter according to claim 19 or the bulk acoustic resonator according to any one of claims 1 to 16.
